# EUROPÄISCHE PATENTSCHRIFT

(11) **EP 3 101 406 B1**
(45) Veröffentlichungstag und Bekanntmachung des Hinweises auf die Patenterteilung: **07.12.2022**
(21) Anmeldenummer: 15170876.5
(22) Anmeldetag: 05.06.2015
(51) Int. Cl.: G01N 1/28, H01J 37/20, G01N 1/32

(54) **VERFAHREN ZUR PRÄPARATION EINER PROBE FÜR DIE MIKROSTRUKTURDIAGNOSTIK SOWIE PROBE FÜR DIE MIKROSTRUKTURDIAGNOSTIK**
METHOD FOR PREPARING A SAMPLE FOR THE MICROSTRUCTURE DIAGNOSIS AND SAMPLE FOR MICRO STRUCTURE DIAGNOSIS
PROCÉDÉ DE PRÉPARATION D'UN ÉCHANTILLON POUR LE DIAGNOSTIC DE MICROSTRUCTURE ET ÉCHANTILLON POUR LE DIAGNOSTIC DE MICROSTRUCTURE

(43) Veröffentlichungstag der Anmeldung: 07.12.2016
(73) Patentinhaber: Fraunhofer-Gesellschaft zur Förderung der angewandten Forschung e.V., 80686 München (DE)
(72) Erfinder: Krause, Michael, 06108 Halle (DE); Schusser, Georg, 06198 Salzatal (DE); Höche, Thomas, 06120 Halle (DE)
(74) Vertreter: Patentanwälte Ruff, Wilhelm, Beier, Dauster & Partner mbB

(56) Entgegenhaltungen:
- DE-A1-102004 001 173
- US-A- 5 270 552
- US-A1- 2002 166 976
- US-A1- 2008 258 056
- US-A1- 2009 119 807
- US-A1- 2010 176 296
- US-A1- 2013 251 914

## Beschreibung

### ANWENDUNGSGEBIET UND STAND DER TECHNIK

Die Erfindung betrifft ein Verfahren zur Präparation einer Probe für die Mikrostrukturdiagnostik, worin durch materialabtragende Laserstrahlbearbeitung aus einem Substrat ein Probenkörper mit vorgebbarer Gestalt präpariert und anschließend ein Zielabschnitt des Probenkörpers mittels Laserstrahlbearbeitung und/oder lonenstrahlbearbeitung zur Freilegung eines für eine Mikrostrukturuntersuchung geeigneten Zielvolumens weiterbearbeitet wird. Die Erfindung betrifft auch eine nach dem Verfahren erhältliche oder hergestellte Probe für die Mikrostrukturdiagnostik.

Seit ihrer Einführung in den 1930er Jahren hat die Transmissionselektronenmikroskopie (TEM) breite Anwendung in verschiedenen Zweigen der Wissenschaft und Wirtschaft gefunden. Aufgrund des im Vergleich zur Lichtmikroskopie deutlich besseren Auflösungsvermögens kann die Mikro- und Nanostruktur verschiedenartiger Präparate sehr detailliert untersucht werden.

Zur chemischen Charakterisierung auf kleinster Längenskala wird auch die Atomsonden-Tomographie (LEAP) eingesetzt. Dieses Verfahren zur Mikrostrukturdiagnostik erlaubt eine zweidimensionale Abbildung und liefert darüber hinaus dreidimensionale Karten der lokalen Zusammensetzung in atomarer Auflösung.

Mit steigender Leistungsfähigkeit der Verfahren zur Mikrostrukturdiagnostik stellt sich in zunehmendem Maße die Frage nach effizienten und schädigungsarmen Verfahren zur Präparation von Proben für diese Verfahren.

Im Bereich der Halbleiter- und Dünnschichttechnologien, aber auch in anderen Technologiegebieten, stellt sich häufig das Problem der Präparation von Querschnitts-Proben. Im Unterschied zu einer Volumenprobe ist eine Querschnitts-Probe eine Probe, die dazu dienen soll, mikrostrukturelle Untersuchungen im Bereich von Grenzflächen zwischen unterschiedlichen, im Bereich einer Grenzfläche aneinander angrenzenden Materialien vorzunehmen, z.B. in Komponenten mit einem Schichtaufbau.

Für die Erzeugung elektronentransparenter Querschnitts-Präparate werden heutzutage im Wesentlichen zwei Routen verfolgt, nämlich (i) der Einsatz von Focussed Ion Beam (FIB)-Systemen zur Erzeugung von Proben mittels fokussierender lonenstrahltechnik direkt aus der Oberfläche eines Substrats und (ii) die Herstellung von Proben anhand von Sandwichverklebungen, welche anschließend mechanisch konfektioniert und dann mittels Ar-Breitstrahl endgedünnt werden.

Die Präparation von Querschnitts-Proben für die Transmissionselektronenmikroskopie in Form von FIB-Lamellen hat infolge ihrer enormen Zielgenauigkeit in den letzten zehn Jahren in nahezu allen Bereichen der Mikrostrukturanalytik weite Verbreitung gefunden. Im Bereich der Metrologie und Strukturaufklärung in hochintegrierten Halbleiterbauelementen wird sie zurzeit aufgrund der zu erreichenden Zielgenauigkeit (einige 10 nm) *de facto* als das einzig praktisch anwendbare Verfahren angesehen.

Grundlegende physikalische Beschränkungen führen jedoch dazu, dass hohe Bearbeitungspräzision mit einer geringen Abtragsrate einhergeht. Aus diesem Grund können mittels FIB-Technik nur sehr kleine Probenkörper mit Abmessungen im Bereich weniger zehn Mikrometer präpariert werden. Für die anschließende TEM-Analyse werden FIB-erzeugte Probenkörper daher auf Trägerstrukturen montiert, die mit standardisierten Probenhaltern von TEM-Anlagen kompatibel sind. Für den Transfer finden *ex-situ-* sowie *in-situ-Lift-out-Techniken* unter Verwendung von Mikro- und Nano-Manipulatoren Anwendung.

Bei dieser Vorgehensweise wird es als nachteilig angesehen, (i) dass die FIB-Anlage vom präzisen Bearbeitungswerkzeug zum teuren Handlingswerkzeug unter Vakuumbedingungen umfunktioniert wird, wodurch die Gerätekapazität für die Bearbeitung sinkt, (ii) dass neben den hohen Anschaffungskosten der eigentlichen FIB-Anlage hohe Zusatzkosten für Manipulatorsysteme ausreichender Präzision notwendig sind, (iii) dass ein gewisses Risiko besteht, dass durch die Komplexität der Mikro- und Nano-Manipulatoren die Fehleranfälligkeit des Gesamtsystems erhöht wird und (iv) dass die Komplexität des Gesamtworkflows sehr gut ausgebildete und erfahrene Bediener erforderlich macht.

Es sind auch schon Verfahren zur Probenpräparation vorgeschlagen worden, die mit einer Kombination aus Laserstrahlbearbeitung und lonenstrahlbearbeitung arbeiten. Dabei wird durch materialabtragende Laserstrahlbearbeitung aus einem Substrat ein Probenkörper mit vorgebbarer Gestalt präpariert und anschließend wird ein Zielabschnitt des Probenkörpers mittels Laserstrahlbearbeitung und/oder lonenstrahlbearbeitung zur Freilegung eines für eine Mikrostrukturuntersuchung vorgesehenen Zielvolumens weiterbearbeitet. Diese Verfahren weisen die prinzipbedingte Schwäche geringer Abtragsraten der FIB-Mikrobearbeitung nicht auf.

Die DE 10 2011 111 190 A1 beschreibt ein Verfahren zur Präparation einer Probe für die Mikrostrukturdiagnostik, bei welchem eine flache Scheibe entlang ihrer beiden gegenüberliegenden Oberflächen jeweils so mit einem energiereichen Strahl bestrahlt wird, dass durch strahlbedingten Materialabtrag in diese beiden Oberflächen jeweils eine etwa parallel zu einer zentralen Scheibenebene verlaufende Vertiefung eingebracht wird, wobei diese beiden Vertiefungen beidseits dieser zentralen Scheibenebene verlaufend so eingebracht werden, dass sich ihre Längsachsen bei Projektion dieser Längsachsen auf diese zentrale Scheibenebene gesehen, unter einem vordefinierten endlichen Winkel schneiden und dass im Schnittbereich der beiden Vertiefungen zwischen diesen ein vorzugsweise bereits elektronenstrahltransparenter Materialabschnitt vordefinierter minimaler Dicke, gesehen senkrecht zu dieser zentralen Scheibenebene als Probe verbleibt. Nach der Laserbearbeitung kann der Bereich geringer Dicke mittels lonenstrahlätzen weiter gedünnt werden.

Die EP 2787338 A1 beschreibt ein Verfahren zur Präparation einer Probe für die Mikrostrukturdiagnostik, bei welchem aus einem flachen Substrat durch Einstrahlen eines Laserstrahls senkrecht und/oder schräg zur Substratoberfläche eine aus Substratmaterial bestehende Basisstruktur herauspräpariert wird, die eine Trägerstruktur und integral damit eine von der Trägerstruktur getragene Struktur umfasst. Die Trägerstruktur kann beispielsweise C-förmig gestaltet sein, während die getragene Struktur als dünner balkenförmiger Zielabschnitt zwischen den Enden der C-förmigen Trägerstruktur ausgebildet sein kann. Die Dicke des Zielabschnitts - gemessen senkrecht zur Substratoberfläche - entspricht der Substratdicke, die Seitenflächen des Zielabschnitts verlaufen parallel zur Substratoberfläche. Das interessierende Zielvolumen liegt im Zielabschnitt und wird nach dem Entnehmen der Basisstruktur aus dem Rest-Substrat und anschließendem Einklemmen der entnommenen Basisstruktur in einen Klemmhalter durch eine weitere Laserstrahlbearbeitung und nachfolgende lonenstrahlbearbeitung herauspräpariert. Bei der Laserstrahlbearbeitung wird der Laserstrahl parallel oder in spitzem Winkel zu den Seitenflächen des plattenförmigen Zielabschnitts eingestrahlt, so dass z.B. elektronentransparente Bereiche entstehen, die senkrecht zur ehemaligen Substratoberfläche durchstrahlt werden können.

Die beiden Verfahren eignen sich hervorragend für die schnelle und zuverlässige Präparation von Volumenmaterialien. Querschnittspräparate können durch entsprechende Konfektionierung des Ausgangsmaterial (z.B. Sandwichverklebung und anschließende mechanische Verkleinerung durch Sägen oder Schleifen) ebenfalls realisiert werden. Allerdings ergibt sich ein zeitlicher Mehraufwand. Für eine gute Zielgenauigkeit ist zudem Erfahrung des Anwenders erforderlich.

Die Patentanmeldung US 2002/0166976 A1 beschreibt zahlreiche Verfahren zur Präparation von Proben für die Mikrostrukturdiagnostik mittels Transmissionselektronenmikroskop (TEM)., worin durch materialabtragende Strahlbearbeitung aus einem Substrat ein Probenkörper mit vorgebbarer Gestalt präpariert und anschließend ein Zielabschnitt des Probenkörpers mittels Laserstrahlbearbeitung und/oder lonenstrahlbearbeitung weiterbearbeitet wird, um ein für ein Mikrostrukturuntersuchung geeignetes Zielvolumen freizulegen. Bei einem Ausführungsbeispiel (Example 17) wird mit einem fokussierten lonenstrahl (FIB) ein Probenkörper aus dem Substrat freigestellt. Dabei entsteht ein Probenkörper, der an einer Probenkörper-Oberseite durch einen Bereich der Substratoberfläche sowie seitlich durch senkrecht zu der Substratoberfläche orientierte Seitenflächen begrenzt ist. Der Probenkörper hat eine Gestalt, die zwei massive Handhabungsabschnitte und dazwischen einen relativ zu den Handhabungsabschnitten dünneren Zielabschnitt aufweist, welcher an einer Schmalseite durch die Probenkörper-Oberseite und seitlich durch senkrecht zur Probenkörper-Oberseite verlaufende Seitenflächen begrenzt ist. Der Probenkörper wird in einen Probenkörper-Halter eingesetzt, der an seiner Oberseite einen langen vertikalen Graben aufweist, in den der Probenkörper eingesetzt wird (Fig. 21K).

### AUFGABE UND LÖSUNG

Vor diesem Hintergrund liegt der Erfindung die Aufgabe zugrunde, ein minimal-invasives, reproduzierbar zuverlässiges, an Artefakten armes und schnelles Verfahren zur gezielten Präparation von Proben für die Mikrostrukturdiagnostik bereitzustellen Das Verfahren soll sich gleichermaßen für Querschnittsproben wie für Volumenproben eignen. Insbesondere soll es möglich sein, in relativ kurzer Zeit Proben höchster Qualität für die Querschnitts-Transmissionselektronenmikroskopie (X-TEM) zu präparieren.

Zur Lösung dieser Aufgabe stellt die Erfindung ein Verfahren mit den Merkmalen von Anspruch 1 bereit. Weiterhin wird die Aufgabe gelöst durch eine Probe mit den Merkmalen von Anspruch 15. Vorteilhafte Weiterbildungen sind in den abhängigen Ansprüchen angegeben. Der Wortlaut sämtlicher Ansprüche wird durch Bezugnahme zum Inhalt der Beschreibung gemacht.

Das Verfahren zur Präparation einer Probe für die Mikrostrukturdiagnostik ist ein mehrstufiges Verfahren, bei welchem in einer früheren Stufe durch materialabtragende Laserstrahlbearbeitung aus einem Substrat ein Probenkörper mit vorgebbarer Gestalt präpariert wird und bei dem anschließend ein Zielabschnitt des Probenkörpers mittels Laserstrahlbearbeitung und/oder Ionenstrahlbearbeitung weiterbearbeitet wird, um ein Zielvolumen freizulegen, welches für eine Mikrostrukturuntersuchung mithilfe eines oder mehrerer Verfahren der Mikrostrukturdiagnostik geeignet sein soll. Das Zielvolumen ist dabei derjenige räumlich begrenzte Bereich des Probenkörpers, in welchem die Mikrostruktur genauer untersucht werden soll. Der Begriff "Probe" bezeichnet diejenige Einheit, die in ein entsprechendes Probenaufnahmesystem einer Anlage zur Mikrostrukturdiagnostik eingebaut werden soll, beispielsweise in ein Probenaufnahmesystem eines Transmissionselektronenmikroskops.

Im Schritt (a) wird der Probenkörper mittels mindestens einer Laserbearbeitungsoperation durch Einstrahlen mindestens eines Laserstrahls senkrecht und/oder schräg zur Substratoberfläche freigestellt. Die Verfahrensführung ist dabei so, dass ein Probenkörper entsteht, welcher an einer Probenkörper-Oberseite durch einen Bereich der Substratoberfläche begrenzt wird. An den im Winkel zur Probenkörper-Oberseite stehenden Seiten wird der Probenkörper durch schräg oder senkrecht zu der Substratoberfläche orientierte Seitenflächen begrenzt. Diese werden durch die Laserbearbeitungsoperation erstmalig freigelegt bzw. erzeugt.

Beim Schritt des Freistellens wird eine Gestalt des Probenkörpers erzeugt, die mindestens einen massiven Handhabungsabschnitt und angrenzend an den Handhabungsabschnitt einen relativ zum Handhabungsabschnitt dünneren Zielabschnitt aufweist. Der Zielabschnitt ist an einer Schmalseite durch die Probenkörper-Oberseite und seitlich durch die senkrecht oder schräg zur Probenkörper-Oberseite verlaufenden Seitenflächen begrenzt. Die Lage des Zielabschnitts wird dabei so gewählt, dass das interessierende Zielvolumen innerhalb des Zielabschnitts liegt.

Die geometrische Gestalt und die Dimensionen des Handhabungsabschnitts und des Zielabschnitts sind für ihre jeweiligen Funktionen optimiert. Der Handhabungsabschnitt (Handlingabschnitt, handling portion) soll dabei so massiv und mechanisch stabil sein, dass eine Handhabung des Probenkörpers in nachfolgenden Verfahrensschritten mithilfe des Handhabungsabschnitts erfolgen kann, ohne am Zielabschnitt angreifen zu müssen. Insoweit hat der Handhabungsabschnitt die Funktion eines Griffabschnitts, an welchem später ein Bediener manuell mithilfe eines Instruments, wie z.B. einer Pinzette, oder aber mithilfe eines Manipulationssystems angreifen kann, um den Probenkörper bei nachfolgenden Verfahrensschritten handzuhaben.

Gemäß der beanspruchten Erfindung ist der Probenkörper derart gestaltet, dass zwischen dem Zielabschnitt und einem angrenzenden Handhabungsabschnitt ein Innenwinkel entsteht, an welchem eine Seitenfläche des Zielabschnitts und eine Seitenfläche des Handhabungsabschnitts unter einem Winkel zusammentreffen.

Der dünnere Zielabschnitt braucht keine besonders hohe mechanische Stabilität aufzuweisen. Seine relevante Dicke kann daher so eingestellt werden, dass bei nachfolgenden materialabtragenden Präparationsschritten zur Freilegung des Zielvolumens nur noch relativ wenig Material abzutragen ist, wodurch die nachfolgenden materialabtragenden Verfahrensschritte nur noch relativ wenig Zeit benötigen. Die Gestalt des Zielabschnitts kann an die Bedürfnisse des vorgesehenen Mikrostrukturdiagnostikverfahrens angepasst sein. Beispielsweise kann der Zielabschnitt eine im Wesentlichen plattenförmige Gestalt haben, was jedoch nicht zwingend ist. Der Zielabschnitt kann auch die Gestalt einer einseitig oder beidseitig gestuften Platte haben und/oder eine Gestalt mit mindestens einer polygonalen Stirnfläche, also einer Stirnfläche, die zwei oder mehr in schrägem Winkel zueinander stehende Flächenabschnitte aufweist.

Örtlich und zeitlich unabhängig vom Freistellen des Probenkörpers wird ein von dem Probenkörper gesonderter Probenkörper-Halter hergestellt. Der Probenkörper-Halter hat Aufnahmestrukturen, die an die Gestalt des Probenkörpers angepasst sind und zum Aufnehmen des Probenkörpers in einer definierten Aufnahmeposition am Probenkörper-Halter ausgelegt sind. Die Herstellung des Probenkörper-Halters kann zeitlich vor dem Freistellungsschritt erfolgen und komplett abgeschlossen sein, bevor der Probenkörper erzeugt wird. Probenkörper-Halter können auf Vorrat gefertigt werden. Es ist auch möglich, dass der Freistellungsschritt sich zeitlich mit dem Herstellen des Probenkörper-Halters überlappt oder zeitlich vollständig nach dem Freistellen des Probenkörpers erfolgt.

Die Aufnahmestrukturen am Probenkörper-Halter sind an die Gestalt des Probenkörpers oder an die Gestalt einer bestimmten Klasse von Probenkörpern u.a. bezüglich ihrer Geometrie angepasst, so dass ein Probenkörper-Halter in der Regel kein Universalhalter ist, sondern im Hinblick auf gewisse Probenkörper-Geometrien optimiert sein kann. Abseits der Aufnahmestrukturen kann der Probenkörper-Halter prinzipiell frei gestaltet werden, insbesondere so, dass er an Aufnahmestrukturen in Vorrichtungen für nachfolgende Verfahrensschritte und für die eigentliche Mikrostrukturuntersuchung passend ist.

Gemäß der beanspruchten Erfindung weisen die Aufnahmestrukturen einen oder mehrere Haltestege zum Fixieren des Probenkörpers auf und an einem Haltesteg ist ein an den Innenwinkel angepasster Außenwinkel ausgebildet

Zu einem geeigneten Zeitpunkt wird im Schritt (c) (Entnahmeschritt, removal step) der freigestellte Probenkörper aus dem Substrat entnommen.

Der entnommene Probenkörper wird danach im Schritt (d) an den Aufnahmestrukturen des zugeordneten Probenkörper-Halters so fixiert, dass er sich in der gewünschten und durch die Gestalt der Aufnahmestrukturen vorgegebenen Aufnahmeposition befindet.

Gemäß der beanspruchten Erfindung wird beim Fixieren des Probenkörpers am Probenkörper-Halter ein definierter Flächenkontakt an zwei winklig zueinander stehenden Flächen des Innenwinkels und des Außenwinkels des Haltestegs erzeugt, so dass die Position des Probenkörpers bezüglich des Probenkörper-Halters zumindest in zwei zueinander senkrechten Richtungen festgelegt ist;

Durch den Schritt (d) des Fixierens entsteht ein fester räumlicher Bezug zwischen Probenkörper und Probenkörper-Halter. Durch die Fixierung hält die Verbindung auch bei Bewegungen oder Erschütterung und/oder in unterschiedlichen Orientierungen.

Der Probenkörper-Halter und der daran fixierte Probenkörper sind die konstituierenden Komponenten der Probe, deren Gestalt und Dimension an Gestalt und Dimension eines Probenaufnahmesystems in einer Anlage zur Mikrostrukturdiagnostik angepasst ist. Es wird somit eine mehrteilige Probe geschaffen, beispielsweise eine zweiteilige Probe aus Probenkörper-Halter und daran fixiertem Probenkörper.

Bei manchen Verfahrensvarianten wird der Probenkörper an den Aufnahmestrukturen durch Kleben mithilfe eines Klebstoffs befestigt bzw. fixiert. Andere Verfahrensvarianten kommen ohne Verwendung von Hilfsmitteln dadurch aus, dass der Probenkörper an den Aufnahmestrukturen durch Klemmen, also rein mechanisch durch Reibschluss befestigt bzw. fixiert wird. Abhängig von den Materialien von Probenkörper und Probenkörper-Halter ist auch eine Verschweißung möglich, z.B. mittels Laserstrahl. Es ist auch möglich, dass z.B. durch Einrasten eine formschlüssige Verbindung zwischen Probenkörper und Aufnahmestrukturen hergestellt wird.

Nach dem Herstellen der Probe durch Fixieren des Probenkörpers am Probenkörper-Halter wird im Schritt (e) mindestens eine weitere materialabtragende Bearbeitung an mindestens einer Seitenfläche des Probenkörpers im Bereich des Zielabschnitts durchgeführt, um das Zielvolumen freizulegen. Für diese(n) finale(n) Bearbeitungsschritt(e) (ein Schritt oder mehrerer Schritte) können eine Laserstrahlbearbeitung und eine lonenstrahlbearbeitung alternativ zueinander oder in Kombination miteinander eingesetzt werden. Häufig wird es so sein, dass die weitere Bearbeitung zunächst mittels Laserstrahlbearbeitung bis nahe zur endgültig gewünschten Gestalt erfolgt und eine lonenstrahlbearbeitung nachgeschaltet wird, um Bearbeitungsreste der Laserstrahlbearbeitung zu beseitigen und das Zielvolumen für die nachfolgende Mikrostrukturuntersuchung endgültig freizulegen.

Das Verfahren und die mithilfe des Verfahrens hergestellten Proben bieten zahlreiche Vorteile im Vergleich zum Stand der Technik.
(i) Die ehemalige Substratoberfläche im Bereich der Probenkörper-Oberfläche kann während der gesamten Probenpräparation weitgehend unangetastet bestehen bleiben. Das Zielvolumen kann somit bei Bedarf in unmittelbarer Nähe der ehemaligen Substratoberfläche (Probenkörper-Oberfläche) liegen. Dadurch ist eine Möglichkeit zur direkten Präparation von Querschnittsproben ohne Sandwichverklebung des Ausgangsmaterials geschaffen.
(ii) Die Beobachtungsrichtung bei einer späteren Mikrostrukturuntersuchung kann parallel oder annähernd parallel zur ehemaligen Substratoberfläche liegen, wodurch unter anderem Grenzflächen zwischen oberflächennahen Schichten beobachtbar werden.
(iii) Die Dicke des Zielabschnitts kann unabhängig von der Substratdicke festgelegt werden. Es entfallen somit Beschränkungen bezüglich der maximalen Substratdicke, die bei manchen herkömmlichen Verfahren existieren.
(iv) Der Zielabschnitt kann bereits vor den finalen Bearbeitungsoperationen in Schritt (e) sehr dünn sein, da der Probenkörper dennoch über den vergleichsweise dickeren, massiveren Handhabungsabschnitt immer manipulierbar bleibt. Ein dünner Zielabschnitt verkürzt die anschließenden Abdünnprozesse, wodurch man schneller zur fertigen Probe kommt.
(v) Weiterhin besteht keine Notwendigkeit des Einsatzes von motorgetriebenen Mikromanipulatoren oder Nanomanipulatoren zur Manipulation der Probe oder des Probenkörpers. Der massive Handhabungsabschnitt kann unabhängig vom Zielabschnitt so ausgelegt werden, dass er auch von einem Bediener mit Pinzette oder einem anderen geeigneten Greifinstrument gegriffen bzw. manipuliert oder aufgenommen werden kann.
(vi) Das Verfahren erlaubt eine nahezu artefaktfreie Realisierung von Proben mit elektronentransparentem Zielvolumen. Auch Proben für andere Untersuchungsverfahren, die kleinste Probendimensionen und eine zielgenaue Präparation fordern, sind möglich.
(vii) Die getrennte Herstellung aneinander angepasster Kombinationen von Probenkörper und Probenkörper-Haltern bietet zudem Potential für eine Steigerung des Durchsatzes der Probenpräparation im Vergleich zu herkömmlichen Verfahren.

In manchen Fällen ist es ausreichend, wenn ein Probenkörper nur einen einzigen Handhabungsabschnitt aufweist. Bei anderen Ausführungsformen werden am Probenkörper ein erster Handhabungsabschnitt und mindestens ein zweiter Handhabungsabschnitt erzeugt, die in einem Abstand zueinander liegen. Zwischen den Handhabungsabschnitten kann ein vergleichsweise dünnerer Zwischenabschnitt liegen. Zwei (oder mehr) Handhabungsabschnitte bieten mehr Möglichkeiten zum Angreifen am Probenkörper bei den späteren Verfahrensschritten. Zudem ist es möglich, mithilfe von zwei zueinander beabstandeten Handhabungsabschnitten eine besonders positionsgenaue und belastbare Fixierung an entsprechend gestalteten Aufnahmestrukturen eines Probenkörper-Halters mit einer Vielzahl von Kontaktflächen zu erreichen.

Ein mechanisch stabiler Handhabungsabschnitt kann an einem Ende des Probenkörpers angebracht sein. Es ist auch möglich, einen Handhabungsabschnitt etwa in der Mitte und/oder mit Abstand zu beider Enden eines Probenkörpers auszubilden. Dieser kann eine definierte Dicke haben, die so bemessen ist, dass er zwischen zwei Stegen oder Schienen einer Aufnahmestruktur weitgehend formschlüssig eingefügt und dann fixiert werden kann. Wenn zwei Handhabungsabschnitte vorgesehen sind, können diese z.B. an den gegenüberliegenden Enden des Probenkörpers angebracht sein, so dass dieser einem Knochen ähneln kann. Die mechanisch stabilen, dickeren Handhabungsabschnitte müssen jedoch nicht am seitlichen Rand des Probenkörpers liegen, sondern können vom Rand nach innen versetzt sein. Drei oder mehr voneinander durch Zwischenabschnitte getrennte Handhabungsabschnitte können z.B. bei sehr langen Probenkörpern aus Gründen der Stabilität sinnvoll sein.

Bei dem zwischen dem ersten Handhabungsabschnitt und dem zweiten Handhabungsabschnitt liegenden Zwischenabschnitt kann es sich um einen Abschnitt des Probenkörpers handeln, der nicht als Zielabschnitt benötigt wird und der hauptsächlich der besseren Fixierung an den Aufnahmestrukturen dienen kann. Bei anderen Ausführungsformen liegt der Zielabschnitt zwischen dem ersten Handhabungsabschnitt und dem zweiten Handhabungsabschnitt, so dass der Zwischenabschnitt dem Zielabschnitt entspricht. Hierdurch kann eine besonders positionsgenaue Fixierung des Probenkörpers und eine sichere Positionierung des Zlelabschnltts am Probenkörper-Halter begünstigt werden.

Beim Schritt (a) des Freistellens kann der Probenkörper in einer durchgehenden Laserbearbeitungsoperation komplett freigestellt werden, so dass er ohne weiteres aus dem Substrat entnommen werden kann. Bei anderen Ausführungsformen wird beim Schritt (a) des Freistellens so vorgegangen, dass an mindestens einer Stelle einer Seitenfläche des Handhabungsabschnitts eine Haltestruktur aus Substratmaterial verbleibt, welche den ansonsten freigestellten Probenkörper im Bereich des Handhabungsabschnitts mit einem angrenzenden Abschnitt des Substrats verbindet, so dass der Probenkörper nur über die Haltestruktur mit dem Rest des Substrats verbunden ist. Dadurch kann erreicht werden, dass der ansonsten freigestellte Probenkörper bei nachfolgenden Operationen zunächst nur durch das Rest-Substrat gehalten wird, so dass keine gesonderte Halteeinrichtung nötig ist. Der freigestellte Probenkörper kann bis zum Entnehmen des Probenkörpers (Schritt (c)) mit dem Substrat verbunden bleiben.

Im Zusammenhang mit dem Entnehmen des Probenkörpers gibt es mehrere Möglichkeiten, die Verbindung zwischen dem (weitgehend) freigestellten Probenkörper und dem Substrat zu lösen. Bei manchen Verfahrensvarianten bewirkt das Entnehmen des Probenkörpers im Schritt (c) unmittelbar eine Trennung der Verbindung zwischen dem Probenkörper und dem Substrat im Bereich der Haltestruktur. Durch den Akt des Entnehmens kann die Haltestruktur z.B. aufgebrochen werden, ohne dass weitere Maßnahmen oder Mittel zum Herauslösen notwendig sind.

Wenn mehrere Handhabungsabschnitte und/oder mehrere Haltestrukturen vorhanden sind, kann auch so vorgegangen werden, dass eine oder mehrere der Haltestrukturen durch Laserstrahlbearbeitung beseitigt werden, so dass der Probenkörper dann frei wird. Prinzipiell kann das Verfahren so geführt werden, dass alle Haltestrukturen mittels Laserbestrahlung entfernt werden. Es ist z.B. möglich, eine Haltestruktur unmittelbar vor der Entnahme mittels Laserstrahl durchzutrennen, ggf. ohne gleichzeitiges Anblasen mit Druckluft. In diesen Fällen ist es in der Regel sinnvoll, an dem Probenkörper vor Auflösen der Haltestrukturen anzugreifen, so dass die folgende Entnahme schnell und einfach vorgenommen werden kann. Prinzipiell ist es auch möglich, dass der Probenkörper aus dem Substrat zunächst nach Auflösen einer letzten Haltestruktur aus dem Substrat herausfällt und später aufgenommen wird.

Der Schritt (a) des Freistellens kann auf unterschiedliche Weisen durchgeführt werden. Bei manchen Verfahrensvarianten wird beim Schritt (a) des Freistellens angrenzend an mindestens eine der Seitenflächen bei der Laserstrahlbearbeitung ein Volumenbereich aus Substratmaterial beseitigt, welcher - gemessen senkrecht zur Normalen der freigelegten Seitenfläche - an einer der mehreren Stellen oder auf gesamter Länge eine Breite aufweist, die ein Vielfaches der Breite einer Laserstrahl-Schnittbahn aufweist. Es wird also eine weiträumige Freistellung im Bereich der jeweiligen Seitenfläche vorgenommen. Hierdurch können angrenzend an eine Seitenfläche relativ (im Vergleich zur Breite einer Laserstrahl-Schnittbahn) große, materialfreie Volumenbereiche entstehen, die eine wirkungsvolle Reinigung der Bearbeitungszone während der Laserbearbeitung durch Anblasen oder Freiblasen begünstigen und die auch zu einem besseren Handling beim Herauslösen beitragen können, weil die Zugänglichkeit des Probenkörpers verbessert wird. Zudem hat sich gezeigt, dass weiträumig freigelegte Seitenflächen eine wesentlich bessere Oberflächenqualität haben können als Flankenflächen eines einfachen Schnittspalts bzw. einer Laserstrahl-Schnittbahn.

Während eine Laserstrahl-Schnittbreite je nach Fokussierung und Material typischerweise im Bereich von ca. 10 µm bis 30 µm liegt, liegt die oben genannte Breite des Volumenbereichs vorzugsweise bei 200 µm oder mehr, z.B. im Bereich von 300 µm bis 400µm.

Die weiträumige Freistellung mit der Erzeugung größerer materialfreier Volumenbereiche kann z.B. durch scannende Führung eines fokussierten Laserstrahls erreicht werden, indem der freizulegende Bereich mit zueinander parallelen Schnitten bzw. teilweise überlappende Schnittbahnen eines fokussierten Laserstrahls sukzessive abgescannt wird.

Es sind auch nicht-scannende Verfahrensvarianten möglich, bei denen durch geeignete Strahlformung erreicht werden kann, dass angrenzend an eine freizulegende Seitenfläche ein größerer Volumenbereich beseitigt wird. Beispielsweise kann beim Freistellen des Probenkörpers ein Verfahren der Maskenprojektion eingesetzt werden, um durch flächige Bestrahlung mit Laserstrahlung zeitgleich größere Volumenbereiche von Substratmaterial zu beseitigen. Eine Strahlformung zur Erzielung eines bestimmten Strahlquerschnitts kann auch mithilfe diffraktiver optischer Elemente oder anderer der Strahlformung dienenden Einrichtungen des Laserbearbeitungssystems erreicht werden. Es können auch Laser, z.B. Festkörperlaser, verwendet werden, die per se einen Linienfokus erzeugen.

Das Verfahren stellt keine besonderen Anforderungen an die Dicke des Substrats, aus welchem der Probenkörper herauspräpariert werden soll. Sofern das Substrat dünn genug ist, kann es beim Freistellen des Probenkörpers ausreichen, den Probenkörper bei der Erzeugung der Seitenflächen aus dem Substrat herauszuschneiden, so dass diejenige Substratoberfläche, die der Probenkörper-Oberseite gegenüberliegt, eine rückseitige Grenzfläche des Probenkörpers bildet. Das ist, abhängig vom Substratmaterial, z.B. bei Substratdicken bis zu ca. 500 µm bis maximal 650 µm in vielen Fällen sinnvoll.

Es ist jedoch auch ohne weiteres möglich, einen Probenkörper aus einem oberflächennahen Bereich eines dicken Substrats herauszupräparieren, ohne das Substrat vollständig zu durchtrennen. Bei einer Verfahrensvariante wird beim Schritt (a) des Freilegens der Probenkörper derart erzeugt, dass eine senkrecht zur Substratoberfläche gemessene Ausdehnung des Probenkörpers geringer ist als eine senkrecht zur Substratoberfläche gemessene Dicke des Substrats. Dabei kann insbesondere so vorgegangen werden, dass beim Schritt (a) des Freilegens in einem Zwischenschritt mittels Laserstrahlbearbeitung zwei in einem Winkel zueinander stehende, gegenüberliegenden Seitenflächen erzeugt werden, welche sich in einer im Inneren des Substrats liegenden Schnittlinie schneiden. Der Winkel kann z.B. weniger als 90° betragen. Der Probenkörper kann somit durch schrägen Einfall von Laserstrahlung von mindestens einer Seite aus der oberflächennahen Region freigestellt werden. Die Probenkörper-Oberseite kann dabei an mindestens einer Seite unterschnitten bzw. hinterschnitten werden. Es ist auch möglich, einen Hinterschnitt oder Unterschnitt an zwei gegenüberliegenden Seiten zu erzeugen. Die relativ zur Oberflächennormalen der Probenkör-per-Oberseite gemessenen Einfallswinkel können beispielsweise im Bereich von ca. 10° bis ca. 55° liegen, häufig sind jedoch nicht mehr als 45° vorgesehen und auch ausreichend. Der Probenkörper kann somit nach dieser Bearbeitungsstufe aus geeigneter Richtung betrachtet annähernd die Form eines Keils haben, der symmetrisch zu einer Mittelebene oder asymmetrisch gestaltet sein kann. Beispielsweise kann eine Seitenfläche senkrecht zur Probenkörper-Oberseite verlaufen, während eine andere schräg auf diese Seitenfläche zuläuft. Es sind auch beidseitige Schrägflächen möglich.

Der Probenkörper kann aus einem Substrat mit einheitlichem Substratmaterial herauspräpariert werden, so dass eine Volumenprobe entsteht. Es ist jedoch auch möglich, dass das Substrat im Bereich der Substratoberfläche eine oder mehrere durch Grenzflächen getrennte Schichten oder Schichtabschnitte bzw. Schichtsegmente aufweist. Ein typisches Beispiel für derartige Substrate sind strukturierte Halbleiterbauelemente. Die Schichten können durchgängig oder lateral strukturiert sein. Mindestens eine Grenzfläche kann im Wesentlichen parallel zur Substratoberfläche verlaufen. Alternativ oder zusätzlich kann es eine oder mehrere Grenzflächen geben, die schräg oder senkrecht zur Substratoberfläche verlaufen. In jedem dieser Fälle kann der Probenkörper derart erzeugt werden, dass eine oder mehrere Grenzflächen im Wesentlichen senkrecht zu mindestens einer Seitenfläche des Zielabschnitts orientiert sind.

Die Formulierung "im Wesentlichen senkrecht" soll hier bedeuten, dass diese Grenzfläche senkrecht oder im stumpfen Winkel, beispielsweise von weniger als 55° bezogen auf die Oberflächennormale, verläuft. Die Formulierung "im Wesentlichen parallel" soll hier bedeuten, dass die Grenzfläche parallel oder im spitzen Winkel, zum Beispiel von weniger als 45° zur Substratoberfläche verläuft. Es bietet sich also die Möglichkeit der Querschnittsproben-Präparation, wie es schon eingangs erwähnt wurde.

Die Gestalt des Probenkörpers kann bei dem Verfahren zweckmäßig an eine korrespondierende Gestaltung passender Aufnahmestrukturen des Probenkörper-Halters angepasst werden. Eine besonders zuverlässige und positionsgenaue Fixierung des Probenkörpers am Probenkörper-Halter lässt sich gemäß der beanspruchten Erfindung dadurch erreichen, dass der Probenkörper derart gestaltet wird, dass zwischen dem Zielabschnitt bzw. Zwischenabschnitt und einem angrenzenden Handhabungsabschnitt ein Innenwinkel entsteht, an welchem eine Seitenfläche des Zielabschnitts bzw. Zwischenabschnitts und eine Seitenfläche des Handhabungsabschnitts unter einem Winkel, beispielsweise unter einem rechten Winkel, zusammentreffen. Dadurch kann ein definierter Anschlag zum Anbringen an korrespondierend gestalteten Aufnahmestrukturen des Probenkörper-Halters erreicht werden. Ein Innenwinkel kann ausreichen, häufig sind jedoch zwei oder mehr derartige Innenwinkel vorgesehen.

Das Konzept der mehrteiligen Probe bietet günstige Gestaltungsmöglichkeiten zur Auslegung des Probenkörper-Halters. Bei manchen Ausführungsformen wird der Probenkörper-Halter aus einem Halter-Material gefertigt, welches sich vom Substratmaterial unterscheidet. Es besteht somit Freiheit bezüglich der Materialwahl für den Probenkörper-Halter, der zum Beispiel unter anderem für seine Haltefunktion unabhängig vom Substratmaterial optimiert werden kann.

Das Halter-Material kann nach Maßgabe einer oder mehrerer der folgenden Kriterien ausgewählt werden.
(i) Für eine zuverlässige Haltefunktion sollte der Halter eine strukturelle Integrität aufweisen, so dass es vorteilhaft sein kann, den Probenkörper-Halter aus einem einzigen Materialstück zu fertigen, auch wenn dies nicht zwingend ist.
(ii) Die Herstellung des Probenkörper-Halters sollte einerseits kostengünstig sein, andererseits sind jedoch gegebenenfalls komplexe Vorgaben hinsichtlich der Gestaltung des Probenhalters, beispielsweise im Bereich der Aufnahmestrukturen, einzuhalten. Die Fertigung erfolgt bei manchen Ausführungsformen daher mittels Laserstrahlbearbeitung aus einer Platte oder Folie eines geeigneten Halter-Materials. In diesen Fällen sollte eine Laserbearbeitbarkeit mit hoher Präzision möglich sein.
(iii) Um die Haltefunktion auch bei den weiteren Bearbeitungsschritten gemäß Schritt (e) zu gewährleisten, sollte das I lalter-Material eine geringere lonenätzrate als das Material des zugeordneten Probenkörpers aufweisen.
(iv) Weiterhin kann es zweckmäßig sein, wenn das Halter-Material gute elektrische Leitfähigkeit und/oder Wärmeleitfähigkeit aufweist.
(v) Für manche Typen von Probenkörpern und/oder nachfolgenden Mikrostrukturuntersuchungsverfahren kann es sinnvoll sein, darauf zu achten, dass das Halter-Material ein chemisches Komplement zum Probenkörpermaterial darstellt, damit nachfolgende chemische Analysen nicht durch Hintergrundsignale beeinträchtigt werden.

Im Hinblick auf eines oder mehrere dieser Kriterien hat es sich in vielen Fällen als vorteilhaft herausgestellt, wenn das Halter-Material ein Metall aufweist oder ein Metall ist. Der Begriff "Metall" soll hier sowohl Reinmetalle als auch metallische Legierungen mit zwei oder mehr Komponenten umfassen. Derzeit wird Titan als ein besonders geeignetes Material angesehen, welches einerseits gut bearbeitbar ist und andererseits niedrigere Ätzraten bei der Ionenbestrahlung aufweist. Metallische Materialien lassen sich darüber hinaus mittels Laserstrahlbearbeitung in sehr komplexen Konfigurationen aus Folie oder Platte, gegebenenfalls auch aus einem massiveren Ausgangsstück, herauspräparieren. Vorzugsweise wird der Probenkörper-Halter mittels Laserbearbeitung aus einer Platte oder einer Folie des Halter-Materials hergestellt. Ein Probenkörper-Halter kann auch durch eine aufbauende Technik, z.B. mittels 3D-Druck, oder über einen MEMS-Prozess hergestellt werden.

Es ist auch möglich, dass ein Probenkörper-Halter teilweise oder vollständig aus einem Kunststoff, aus Graphit oder einer anderen Form elementaren Kohlenstoffs oder aus einem keramischen Werkstoff, wie z.B. Al₂O₃, besteht.

Für eine positionsgenaue Fixierung des Probenkörpers am Probenkörper-ist gemäß der beanspruchten Erfindung vorgesehen, dass die Aufnahmestrukturen einen oder mehreren Haltestege zum Fixieren des Probenkörpers aufweisen, wobei an einem Haltesteg mindestens eine Anschlagsfläche zum Anlegen einer korrespondierenden Seitenfläche des Probenkörpers ausgebildet ist. An einem Haltesteg ist ein an den oben genannten Innenwinkel angepasster Außenwinkel, beispielsweise ein rechter Winkel, ausgebildet. Hierdurch ist beim Fixieren des Probenkörpers am Probenkörper-Halter ein definierter Flächenkontakt an zwei winklig zueinander stehenden Flächen möglich, so dass die Position des Probenkörpers bezüglich des Probenkörper-Halters zumindest in zwei zueinander senkrechten Richtungen festgelegt ist. Es kann eine weitere Anschlagsfläche quer bzw. senkrecht dazu vorgesehen sein.

In vielen Fällen erscheint es sinnvoll, wenn die Aufnahmestrukturen so erzeugt werden, dass sie einen oder mehrere Haltestege zum Fixieren des Probenkörpers aufweisen, wobei ein Haltesteg einen ersten Stegabschnitt und einen in einem Winkel zum ersten Stegabschnitt ausgerichteten zweiten Stegabschnitt aufweist. Der genannte Winkel kann vorzugsweise ein rechter Winkel sein. Die Winkelform eines Haltestegs kann beispielsweise eine L-Form oder eine T-Form sein. Mit drei zueinander im Winkel stehenden Stegabschnitten sind Aufnahmestrukturen in Form von Ösen (Rechteck-Ösen) möglich. Derartige Formen bieten als Anschlagflächen geeignete Außenwinkel und Innenwinkel in mehreren Richtungen. Es können relativ kleine, definierte Kontaktzonen zwischen aneinander anliegenden, vorzugsweise ebenen Flächenabschnitten des Probenkörpers und eines Haltestegs gebildet werden, die bei der Fixierung mittels Klebstoff dafür sorgen, dass Klebstoff nur in den für die Klebefunktion erforderlichen kleinen Flächenbereichen verbleibt.

Es sind viele unterschiedliche Klebstoffe verwendbar. Ein Klebstoff sollte relativ schnell aushärten, aber eine gewisse Korrekturmöglichkeit beim Fixieren bieten, ausreichende Viskosität für eine gute Benetzung haben und vakuumtauglich sein.

Eine Zielpräparation oberflächennaher Bereiche kann insbesondere bei relativ leicht ätzbarem Probenkörper-Material schwierig sein. Bei manchen Ausführungsformen wird diesem Umstand dadurch Rechnung getragen, dass die Aufnahmestrukturen so gestaltet werden, dass sie einen an die Probenkörper-Oberseite angepassten Abschattungssteg aufweisen bzw. bilden, der aus einem Material besteht, welches bei lonenbestrahlung und/oder Laserbestrahlung eine niedrigere Ätzrate bzw. Abtragsrate aufweist als das Substratmaterial. Hierdurch können die Vorteile der an sich bekannten Methode der "Drahtabschattung" durch besondere Ausgestaltung der Aufnahmestrukturen nutzbar gemacht werden, ohne dass gesonderte Abschattungselemente, wie beispielsweise ein Abschattungsdraht, verwendet werden müssen. Zu Details der bekannten Drahtabschattungs-Technik sei beispielhaft auf den Artikel "Optimisation of the wire-shadow TEM cross-section preparation technique" von S. Senz et al. in Ultramicroscopy 70 (1997) Seiten 23 - 28 verwiesen.

Alternativ oder zusätzlich ist es auch möglich, vor dem Fixieren des Probenkörpers an den Aufnahmestrukturen auf die Probenkörper-Oberseite mindestens im Bereich der Schmalseite des Zielabschnitts eine Opferschicht aufzubringen, die aus einem Material besteht, welches bei Laserbestrahlung und/oder lonenbestrahlung eine niedrigere Abtragsrate (Materialabtragsrate) bzw. Ätzrate aufweist als das Substratmaterial und vorzugsweise auch zu einem verbesserten Wärmemanagement beiträgt, indem die Opferschicht eine bessere Wärmeleitfähigkeit aufweist als das Substratmaterial.

Sowohl ein Abschattungssteg als auch eine Opferschicht kann bewirken, dass das dadurch gegen Laserstrahlen und/oder lonenstrahlen zunächst abgeschattete Substratmaterial erst abgetragen würde, wenn das schützende Material des Abschattungsstegs oder der Opferschicht aufgebraucht bzw. abgetragen ist. Wird die Laserbestrahlung und/oder lonenbestrahlung kurz vor, bei oder kurz nach Erreichen dieses Zustands beendet, kann ein Zielvolumen unmittelbar im Anschluss an den Abschattungssteg bzw. die Opferschicht verbleiben und nachfolgend beobachtet werden.

Die Erfindung bezieht sich auch auf eine mehrteilige Probe für die Mikrostrukturdiagnostik, die durch ein Verfahren der in dieser Anmeldung beschriebenen Art hergestellt werden kann oder hergestellt wurde. Die Probe weist einen Probenkörper-Halter mit Aufnahmestrukturen zum Aufnehmen eines Probenkörpers in einer definierten Aufnahmeposition auf. Weiterhin weist die Probe mindestens einen gesondert von dem Probenkörper-Halter hergestellten Probenkörper auf, der mindestens einen massiven Handhabungsabschnitt und angrenzend an den Handhabungsabschnitt einen relativ zum Handhabungsabschnitt dünneren Zielabschnitt aufweist, welcher an einer Schmalseite durch eine Probenkörper-Oberseite und seitlich durch senkrecht oder schräg zur Probenkörper-Oberseite verlaufende Seitenflächen begrenzt ist. Der Probenkörper ist an den Aufnahmestrukturen in der Aufnahmeposition fixiert.

### KURZBESCHREIBUNG DER ZEICHNUNGEN

Weitere Vorteile und Aspekte der Erfindung ergeben sich aus den Ansprüchen und aus der nachfolgenden Beschreibung von bevorzugten Ausführungsbeispielen der Erfindung, die nachfolgend anhand der Figuren erläutert sind.
Fig. 1 zeigt in den Teilfiguren 1A bis 1F verschiedene Phasen beim Herauspräparieren eines Probenkörpers aus einem Substrat bei einem Ausführungsbeispiel;
Fig. 2 zeigt eine schrägperspektivische Ansicht eines Probenkörpers;
Fig. 3 zeigt den Probenkörper aus Fig. 2 nach Fixieren des Probenkörpers an einem daran angepassten Probenkörper-Halter;
Fig. 4 zeigt ein Beispiel für einen Probenkörper-Halter, dessen Aufnahmestrukturen einen an die Probenkörper-Oberseite angepassten Abschattungssteg aufweisen;
Fig. 5 zeigt ein Beispiel eines Probenkörper-Halters mit zwei identisch gestalteten Aufnahmestrukturen zur Aufnahme von zwei Probenkörpern;
Fig. 6 zeigt eine Probe, die zwei aneinander angepasste Probenkörper-Halter aufweist, welche jeweils zwei daran fixierte Probenkörper tragen;
Fig. 7 zeigt einen Probenkörper-Halter mit einem T-förmigen Haltesteg und einem daran fixierten Probenkörper;
Fig. 8 zeigt einen anderen Probenkörper-Halter mit einem T-förmigen Haltesteg und einem daran fixierten aufrecht stehende Probenkörper.

### DETAILLIERTE BESCHREIBUNG DER AUSFÜHRUNGSBEISPIELE

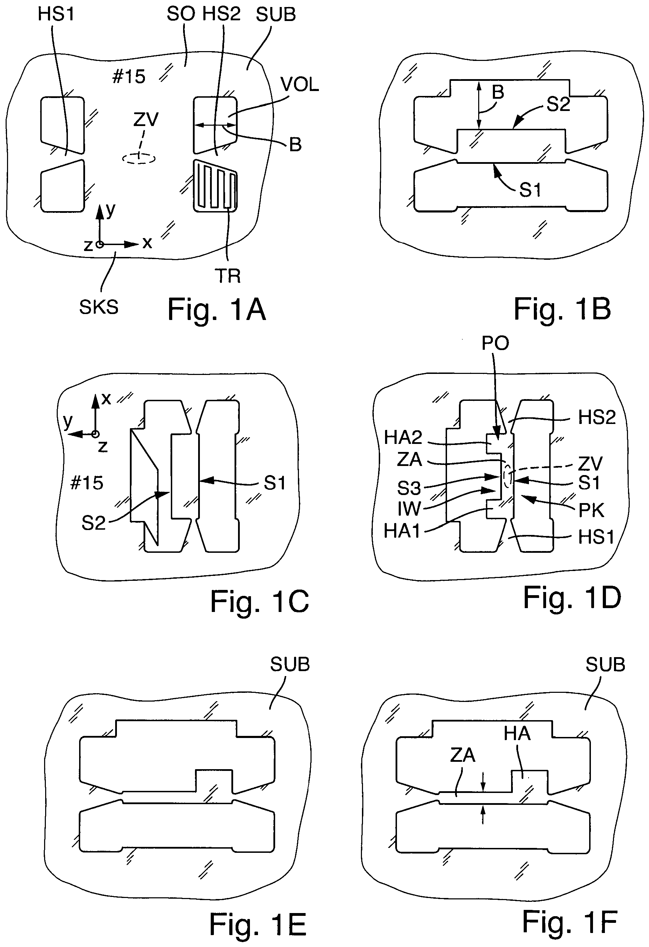

Im Folgenden werden zunächst anhand der Fig. 1 bis 3 verschiedene Aspekte eines Verfahrens zur Herstellung einer Querschnittsprobe für die Transmissionselektronenmikroskopie (TEM) beispielhaft beschrieben. Dabei wird aus einem gezielt ausgewählten Bereich eines Substrats SUB ein Probenkörper herauspräpariert, der später in einem daran angepassten Probenkörper-Halter befestigt wird und gemeinsam mit diesem eine Probe für die Mikrostrukturdiagnostik mittels TEM bilden soll.

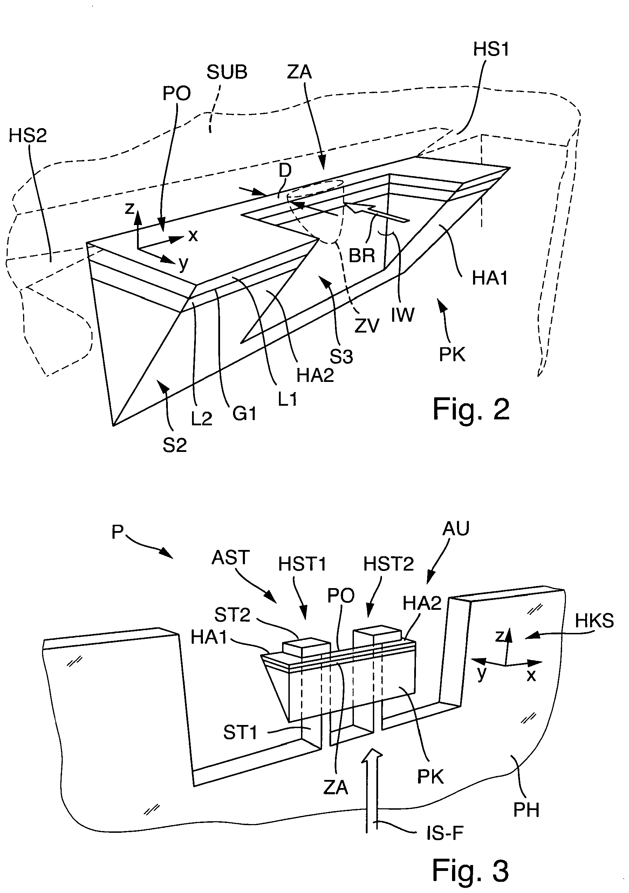

Die schematische Fig. 1 zeigt in den Teilfiguren 1A bis 1F verschiedene Phasen des Herauspräparierens eines Probenkörpers aus dem Substrat SUB. In Fig. 2 ist eine schrägperspektivische Ansicht eines Probenkörpers gezeigt, Fig. 3 zeigt den Probenkörper aus Fig. 2 nach Fixieren des Probenkörpers an einem daran angepassten Probenkörper-Halter.

Fig. 1A zeigt in Draufsicht einen Ausschnitt der Substratoberfläche SO eines Substrats SUB, aus welchem ein Probenkörper herauspräpariert werden soll, der einen Ausschnitt der Substratoberfläche enthält. Zur besseren Orientierung ist ein Substratkoordinatensystem SKS eingezeichnet. Das Zielvolumen ZV, welches später mittels TEM untersucht werden soll, grenzt in z-Richtung unmittelbar an die Substratoberfläche SO an. Die Substratoberfläche ist im Beispielsfall eben, sie kann auch gekrümmt sein. Eine Vorpräparation der Substratoberfläche ist in der Regel nicht notwendig, sie braucht beispielsweise nicht poliert zu sein. Bei dem Substrat kann es sich beispielsweise um ein mehrschichtig aufgebautes Halbleiterbauelement handeln.

Aus dem oberflächennahen Bereich wird durch sukzessiven Abtrag von Material mittels Laserstrahlbearbeitung sowohl unter senkrechtem als auch unter schrägem Einfall eines Laserstrahls ein weitgehend frei wählbares Probenvolumen an einer definierten Stelle freigestellt. Dazu werden zunächst Bereiche mit späteren Haltestrukturen HS1, HS2 erzeugt (Fig. 1A). Anschließend wird unter teilweise senkrechtem, teilweise schrägem Einfall des Laserstrahls die Grundstruktur des zu entnehmenden Probenkörpers PK freigestellt, der nur noch im Bereich der Haltestrukturen mit dem Rest des Substrats in Verbindung steht (Fig. 1B und 1C). Der bis dahin erzeugte Probenkörper-Rohling hängt nur noch im Bereich der Haltestrukturen mit dem Rest des Substrats zusammen.

In nachfolgenden Bearbeitungsphasen wird, ebenfalls mittels eines fokussierten Laserstrahls, ein mittlerer Abschnitt des Probenkörper-Rohlings durch weiteren Materialabtrag abgedünnt, so dass ein relativ schmaler Zielabschnitt ZA entsteht, der das Zielvolumen ZV enthält. An beiden Längsenden des Zielabschnitts bleiben strukturell massivere bzw. dickere Abschnitte übrig, in deren Bereich die Haltestrukturen mit dem Rohling des Probenkörpers in Verbindung stehen. Diese massiven Abschnitte dienen dem späteren Handling des Probenkörpers PK und werden daher in dieser Anmeldung als Handhabungsabschnitte HA1, HA2 bzw. Handlingabschnitte bezeichnet (Fig. 1D). Der auf diese Weise hergestellte Probenkörper ist somit durch eine geringe Dicke im Bereich des Zielvolumens, d.h. im Zielabschnitt, aber auch durch mechanisch besonders stabile Bereiche am Rand (Handhabungsabschnitte) gekennzeichnet.

Während der gesamten Laserbearbeitung wird der Probenkörper nur durch die beiden, an den gegenüberliegenden Handhabungsabschnitten angrenzenden Haltestrukturen HS1, HS2 gehalten, die sich zum Probenkörper hin keilförmig verjüngen und am Übergang zu den dickeren Handhabungsabschnitten jeweils eine Sollbruchstelle bilden. Durch die Halterung des Probenkörpers mittels der Haltestege ist es in diesen Phasen der Bearbeitung möglich, jegliche Bearbeitungsrückstände (Debris) der Laserbearbeitung durch Abblasen mit Druckluft oder einem anderen unter Druck stehenden Gas zu reinigen, ohne dass der Probenkörper dadurch weggeblasen wird. Die in Fig. 1D in Draufsicht gezeigte Konfiguration ist auch in der schrägperspektivischen Ansicht von Fig. 2 dargestellt.

Es können sich weitere Bearbeitungsschritte an dem durch die Haltestrukturen im Substrat gehaltenen Probenkörper anschließen. Insbesondere kann, wie in Fig. 1E gezeigt ist, einer der massiven Handhabungsabschnitte noch durch Laserbearbeitung beseitigt werden, so dass der resultierende Probenkörper L-Form aufweist und nur einen einzigen massiven Handhabungsabschnitt sowie daran angrenzend einen dünnen Zielabschnitt hat, wobei eine der Haltestrukturen an den Handhabungsabschnitt und die gegenüberliegende Haltestruktur am Zielabschnitt angreift. Der dadurch erzeugte Probenkörper kann dann durch weitere Laserbearbeitung im Bereich des Zielabschnitts weiter abgedünnt werden (Fig. 1F).

Der auf diese Weise lasermikrobearbeitete Probenkörper kann dann in einem weiteren Verfahrensschritt z.B. unter Nutzung einer herkömmlichen Pinzette, z.B. einer Inverspinzette, aus dem Substrat entnommen werden. Ein Bediener würde dabei nur am Handhabungsabschnitt angreifen und den dünneren Zielabschnitt nicht berühren. Der Probenkörper kann im Bereich der Sollbruchstellen an den dünnsten Stellen der Haltestrukturen HS1, HS2 aus dem Rest-Substrat herausgebrochen werden und ist dann für die weitere Handhabung frei.

Eine zur Durchführung der genannten Verfahrensschritte geeignete Laserbearbeitungsvorrichtung weist einen Laser, einen Galvanometer-Scanner sowie eine Fokussieroptik auf, um einen auf das Substrat gerichteten, fokussierten Laserstrahl erzeugen zu können und um den Laserstrahl entlang vorher programmierbarer Trajektorien zu führen. Auch Laserbearbeitungsvorrichtungen mit anderen Positioniereinheiten, welche eine steuerbare Relativbewegung zwischen Laserstrahl und Substrat ermöglichen, können genutzt werden. Das Substrat, aus welchem der Probenkörper entnommen werden soll, wird in einer Werkstückaufnahme aufgenommen. Die Werkstückaufnahme kann bei Bedarf gegen eine Halterung zum Nachbereiten getauscht werden. Weiterhin kann die Werkstückaufnahme um eine Achse gekippt und um eine davon unabhängige Achse rotiert werden, um für jeden Auftreffort den Einfallswinkel und die Einfallsrichtung des Laserstrahls frei programmierbar einstellen zu können. Außerdem kann durch x-y-Verschiebung des Substrats die Zielposition exakt in der euzentrischen Kippachse der Werkstückaufnahme positioniert werden. Die Laserbearbeitungsvorrichtung ist weiterhin mit einem Anblassystem und einem Absaugsystem ausgerüstet. Mithilfe des Anblassystems kann der aktuell mittels Laserstrahl bearbeitete Bereich angeblasen werden, um mithilfe des Druckgases entstehende Bearbeitungsrückstände fortzutragen, so dass sich diese nicht am bearbeiteten Rest des Substrats absetzen können. Mit dem Absaugsystem können die Bearbeitungsreste umweltverträglich abgesaugt werden. Weiterhin ist eine Beobachtungseinrichtung mit einer Digitalkamera vorgesehen, mit der auf wenige Mikrometer genau die jeweilige Zielstelle anvisiert werden kann. Die Programmierung und Bedienung erfolgt über eine Softwareoberfläche an einer Bedieneinheit, welche auch die zentrale Steuerung der Laserbearbeitungsvorrichtung enthält.

Im Zuge der Laserbearbeitung kann zur Nachverfolgbarkeit im Rahmen von QM-Systemen eine Markierung der Probenkörper-Halter etwa mit der Probenbezeichnung, fortlaufenden Nummern oder einem Matrixcode oder Barcode erfolgen.

Die anhand von Fig. 1 beispielhaft dargestellte Bearbeitungsstrategie nutzt diese apparativen Möglichkeiten im Sinne einer schnellen und schonenden Präparation eines Probenkörpers. Ausgehend vom Substrat SUB mit unverletzter Oberfläche wird der in Fig. 1A gezeigte Bearbeitungszustand dadurch erreicht, dass der fokussierte Laserstrahl in den durch Laserstrahlbearbeitung zu beseitigenden Volumenbereichen mithilfe des Galvanometer-Scanners in einer mäandrierenden Trajektorie TR (oder durch eine andere scannende Bewegung, z.B. Linienvorschub) geführt wird, so dass etwa quaderförmige bzw. polygonal begrenzte Volumenbereiche VOL aus dem Substratmaterial beseitigt werden. Die (senkrecht zu den begrenzenden Seitenflächen gemessene) Breite B der Volumenbereiche entspricht einem Vielfachen der Breite einer Laserstrahl-Schnittbahn. Die Breite B kann z.B. im Bereich von 200 µm bis 400 µm liegen. Dadurch entstehen angrenzend an die freigelegten Seitenflächen große Freiräume, die eine Reinigung mittels Freiblasens erleichtern und auch beim späteren Handling einen erleichterten Zugriff auf den zu entnehmenden Probenkörper bieten. Die weiträumige Freilegung erlaubt es, die Seitenflächen mit sehr guter Oberflächenqualität zu erzeugen. Die Bearbeitungsstrategie (z.B. mittels Mäander, Boxen, Linien etc.) hat erheblichen Einfluss auf die Qualität der freigelegten Seitenflächen. Die Seitenflächen sind in der Regel deutlich glatter als Flankenflächen einer Laserschnittbahn.

In dieser Phase wird mit nahezu senkrechtem Einfall des Laserstrahls gearbeitet, also mit einer Einfallsrichtung des Laserstrahls etwa parallel zur Oberflächennormalen des Substrats (z-Richtung). Wenn mittels eines fokussierten Laserstrahls eine zur Probenoberfläche senkrechte Seitenfläche erzeugt werden soll, ist ein leichtes Gegenkippen (um einige Grad) vorgesehen erforderlich, um den Flankenwinkel zu kompensieren.

Anschließend werden die in y-Richtung einander gegenüberliegenden Seitenflächen des heraus zu präparierenden Probenkörpers herausgearbeitet, indem entsprechende rechteckförmige Volumina des Substratmaterials bei schrägem sowie senkrechtem Einfall des Laserstrahls herausgearbeitet werden. Die Fig. 1B und 1C zeigen den gleichen Bearbeitungszustand in um 90° gegeneinander verdrehten Orientierungen. In der Perspektive von Fig. 1C ist gut zu erkennen, dass an den (parallel zur x-Richtung verlaufenden) Längsseiten des freizustellenden Probenkörpers mit schrägem Einfall des Laserstrahls gearbeitet wurde, um einen Probenkörper zu schaffen, welcher die Form eines asymmetrischen Prismas hat. Eine erste Seitenfläche bzw. Flankenfläche S1 verläuft dabei senkrecht zur Substratoberfläche, die gegenüberliegende ebene zweite Seitenfläche S2 verläuft schräg zur Substratoberfläche nach Art einer Hinterschneidung. Die beiden jeweils ebenen Seitenflächen S1 und S2 schneiden sich mit Abstand unterhalb der Substratoberfläche im Inneren des Substrats in einer Tiefe, die nur einem Bruchteil der Substratdicke entspricht, die senkrecht zur Substratoberfläche gemessen wird. Der Probenkörper kann also auch aus einem oberflächennahen Bereich herauspräpariert werden, ohne dass , das Substrat auf gesamter Dicke durchtrennt werden muss.

Die in Fig. 1C gezeigte Situation stellt eine Zwischenstufe der Bearbeitung dar, in der der Probenkörper noch nicht seine spätere, für die Entnahme vorgesehene Gestalt erhalten hat. Anschließend wird in einem mittleren Abschnitt zwischen den äußeren Haltestrukturen der Probenkörper in y-Richtung weiter abgedünnt, indem durch Laserstrahlbearbeitung mit nahezu senkrechtem Strahleinfall Substratmaterial so beseitigt wird, dass die in Fig. 1D gezeigte Hantelform des Probenkörpers entsteht, welche auch in Fig. 2 dargestellt ist. Der Probenkörper PK hat jetzt angrenzend an die erste Haltestruktur HS1 einen ersten Handhabungsabschnitt HA1, angrenzend an die gegenüberliegende zweite Haltestruktur HS2 einen zweiten Handhabungsabschnitt HA2, und zwischen den Handhabungsabschnitten einen im Vergleich dazu dünneren Zielabschnitt ZA, in welchem das Zielvolumen ZV liegt. Die in dieser Draufsicht C-förmig erscheinende Probenkörper-Oberseite PO wird dabei durch einen entsprechend geformten Ausschnitt der Substratoberfläche SO gebildet.

Die ebene erste Seitenfläche S1 steht senkrecht auf der Probenkörper-Oberseite und verläuft in z-Richtung des Substrats. Die gegenüberliegende Seitenfläche S3 verläuft parallel zur ersten Seitenfläche S1, so dass der Zielabschnitt ZA die Gestalt einer planparallelen Platte hat. Durch das Wegschneiden des mittleren Abschnitts zur Erzeugung der Seitenfläche S3 sind am Übergang zwischen dem Zielabschnitt ZA und den angrenzenden Handhabungsabschnitten jeweils rechtwinklige Innenwinkel IW entstanden. Die im Bereich der Innenwinkel aneinanderstoßenden ebenen Seitenflächen fungieren später beim positionsrichtigen Fixieren des Probenkörpers am zugeordneten Probenkörper-Halter als Anschlagsflächen, die eine präzise Positionierung und x- und y-Richtung ermöglichen, vgl. Fig. 3.

Die schematische Fig. 2 zeigt eine Ansicht eines Probenkörpers PK vergleichbarer Geometrie, der aus einem Substrat herauspräpariert wurde, welches im Bereich der Substratoberseite zwei dünne Schichten L1, L2 auf einem Volumenmaterial enthielt, wobei die dünnen Schichten durch eine oberflächenparallele Grenzfläche G1 getrennt sind. Es ist erkennbar, dass der dünne Zielabschnitt ZA senkrecht zur ehemaligen Substratoberfläche ausgerichtet ist, so dass bei ausreihender Reduzierung der parallel zur Substratoberseite in y-Richtung gemessenen Dicke des Zielabschnitts eine Untersuchung der Grenzfläche G1 und der angrenzenden Schichten L1, L2 in einer Beobachtungsrichtung BR möglich ist, die im Wesentlichen parallel zur Grenzfläche G1 und den angrenzenden Schichten verläuft (Pfeil). Mit dem Verfahren ist somit eine Querschnittspräparation ohne weiteres möglich.

Wie oben bereits erwähnt, kann der Zielabschnitt bei noch im Substrat festgehaltenem Probenkörper bereits auf sehr dünne Gesamtdicke D gedünnt werden, bevor der Probenkörper aus dem Substrat herausgelöst wird.

Folgende typische Dimensionen von Handhabungsabschnitt und Zielabschnitt haben sich als besonders praktikabel herausgestellt. Abweichungen sind möglich. Der Zielabschnitt sollte möglichst dünn sein, damit die nachfolgenden Bearbeitungsschritte möglichst wenig Zeit benötigen. Gesamtdicken D bis hinunter zu ca. 40 µm scheinen regelmäßig möglich, die Mindestdicke kann materialabhängig variieren. Die in der gleichen Richtung (y-Richtung) gemessene Dicke der Handhabungsabschnitte ist meist mehrfach größer und kann ebenfalls materialabhängig optimiert werden. Sie hängt unter anderem von der Festigkeit des Substratmaterials ab. Für Silizium und andere Halbleiterwerkstoffe sollte ein Handhabungsabschnitt z.B. mindestens 200 µm dick sein, die Dicke bzw. Länge in x-Richtung kann in der gleichen Größenordnung liegen. Für Materialien mit höherer Festigkeit, wie z.B. Saphir (Al₂O₃) können Dicken von 100 µm bis 150 µm in y-Richtung ausreichen.

Beim beschriebenen Ausführungsbeispiel wird der Probenkörper PK mit dem noch nicht fertig gedünnten Zielabschnitt aus dem Substrat entnommen und an einem speziell an die Probenkörper-Geometrie angepassten Probenkörper-Halter PH in einer definierten Aufnahmeposition fixiert (vgl. Fig. 3).

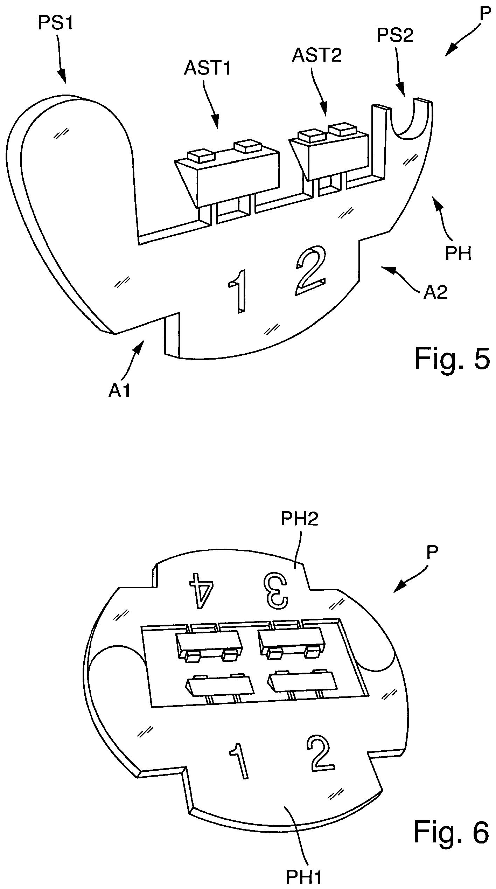

Der Probenkörper-Halter PH des Ausführungsbeispiels ist ein einstückiges, flaches Funktionselement, welches mittels Laserbearbeitung aus einer dünnen Folie eines metallischen Werkstoffs (beispielsweise Titan) passend zur Geometrie des Probenkörpers präpariert wurde. Der generell plattenförmige Probenkörper-Halter PH hat etwa die Grundform eines Halbkreises (vgl. Fig. 5), an dessen kreishalbierender Seite eine rechteckförmige (oder anders gestaltete) Aussparung AU ausgebildet ist. An der gegenüberliegenden bogenförmigen Seite sind einander gegenüberliegend zwei dreieckförmige Aussparungen A1, A2 vorgesehen, die durch zwei senkrecht zueinander ausgerichtete Kanten begrenzt sind. Diese Geometrie erleichtert die lagerichtige Anbringung des Probenkörper-Halters bzw. der gesamten Probe in einem hier nicht näher beschriebenen Klemmhalter, der für weitere Bearbeitungsschritte genutzt werden kann. Die Geometrie des Probenhalters ähnelt insoweit der Geometrie von Proben, welche in der EP 2787338 A1 zusammen mit der Funktion dieser Aussparungen beschrieben ist. Insoweit wird auf die dortige Beschreibung verwiesen.

Im Bereich der Aussparung AU an der Oberseite sind mittig Aufnahmestrukturen AST herausgearbeitet, die es erlauben, den strukturell daran angepassten Probenkörper PK in einer bezüglich des Halter-Koordinatensystems HKS genau definierten Aufnahmeposition am Probenkörper-Halter aufzunehmen. Die Aufnahmestrukturen AST umfassen im Beispielsfall zwei spiegelsymmetrisch zu einer Mittelebene angeordnete, jeweils L-förmig gestaltete Haltestege HST1, HST2 zum Fixieren des Probenkörpers. Jeder der Haltestege HST1, HST2 hat einen in der gezeigten Konfiguration vertikalen ersten Stegabschnitt ST1, der vom massiven Teil abragt und an seinem freien Ende einen im rechten Winkel dazu stehenden, kürzeren zweiten Stegabschnitt ST2 trägt, welcher zu der dem anderen Haltesteg abgewandten Seite nach außen wegragt. Die Stegabschnitte ST1, ST2 haben jeweils Rechteckquerschnitt und bilden zueinander einen rechten Winkel.

Bei nicht dargestellten Varianten gibt es jeweils noch einen zum ersten Stegabschnitt parallelen dritten Stegabschnitt, der außen an den zweiten Stegabschnitt anschließt, so dass die Stegabschnitte eine rechteckige Öse bzw. eine Öse mit Rechtecköffnung bilden.

Der laterale Abstand (in x-Richtung) der einander abgewandten Außenseiten der vertikalen ersten Stegabschnitte ST1 ist um einige 10 µm (z.B. maximal 50 µm) kleiner als der lichte Abstand der einander zugewandten Seitenflächen der Handhabungsabschnitte HA1, HA2, so dass der Probenkörper nach seitlichem Aufschieben auf die Haltestege (in γ-Richtung) mit geringem Spiel in x-Richtung an den Haltestegen sitzt und mit seiner Innenseite in y-Richtung an den Haltestegen anschlagen kann. Die nach außen abragenden kürzeren zweiten Stegabschnitte ST2 bilden in Längsrichtung der ersten Stegabschnitte ST1 (d.h. in z-Richtung) eine Anschlagsfläche, an die der Probenkörper mit der Probenkörper-Oberseite PO anschlagen kann. Somit ist die Aufnahmeposition des Probenkörpers in y-Richtung und in Hochrichtung (z-Richtung) durch Anschläge an den Haltestegen definiert.

Besonders vorteilhaft, wenngleich auch nicht zwingend nötig, ist hierbei die Probenkörper-Geometrie mit den zwei in lateralem Abstand zueinander liegenden massiven Handhabungsabschnitten und einer zur Oberfläche senkrechten Innenfläche bzw. Innenflanke, da diese wohldefiniert entlang der beiden Haltestege HST1, HST2 des Probenkörper-Halters PH in die entsprechenden Anschläge geführt werden kann. Vor dem Anbringen des Probenkörpers werden die in Kontakt miteinander zu bringenden Abschnitte der Flächen von Probenkörper PK und/oder Haltestegen HST1, HST2 mit einem Kleber benetzt. Dieser verteilt sich beim Anbringen des Probenkörpers im Wesentlichen nur im Bereich des engen Kontakts zwischen Probenkörper und Haltestegen, so dass eine äußerst haltbare, saubere Klebeverbindung unter Verwendung von minimalen Mengen eines geeigneten Klebstoffs erreicht werden kann.

Sowohl beim Entnehmen des Probenkörpers aus dem Substrat als auch beim Fixieren des Probenkörpers an den Haltestegen der Aufnahmestrukturen des Probenkörper-Halters gestatten es die mechanisch stabilen Handhabungsabschnitte HA1, HA2, den Probenkörper mit einer Pinzette unter Beobachtung in einem einfachen Stereo-Lichtmikroskop zu manipulieren.

Für die kompletten Bearbeitungsschritte inklusive der Laserbearbeitung, dem Transfer des Probenkörpers PK von dem Substrat SUB zum Probenkörper-Halter PH und der Fixierung am Probenkörper-Halter sind keine besonderen Anforderungen an die Umgebungsatmosphäre gestellt, so dass diese Schritte in normaler Laboratmosphäre vorgenommen werden können. Insbesondere eine Arbeit unter Vakuum ist hier nicht erforderlich.

Die Fig. 3 zeigt die zweiteilig aufgebaute Probe P, die im Wesentlichen (bis auf das Klebermaterial) nur aus dem Probenkörper-Halter PH und dem daran befestigten Probenkörper PK besteht. Diese Probe kann dann weiteren Bearbeitungsschritten zugeführt werden. Insbesondere kann die Probe nach Abschluss der Fixierung des Probenkörpers am Probenkörper-Halter in einen speziellen Klemmhalter transferiert werden, um danach den Zielabschnitt ZA mittels Laserstrahlbearbeitung im Wesentlichen senkrecht von oben auf eine (in y-Richtung gemessene) Stegdicke von beispielsweise ca. 10 µm Dicke präzise abzudünnen. Obwohl es theoretisch möglich ist, diese Rückdünnung noch an dem im Substrat gehaltenen Probenkörper vorzunehmen, sollte diese Rückdünnung zweckmäßig erst nach Befestigung des Probenkörpers PK am Probenkörper-Halter PH erfolgen, da auf diese Weise die notwendigen geometrischen Randbedingungen für den unmittelbaren Abtransport von Bearbeitungsrückständen (Debris) besonders einfach und zuverlässig zu erreichen sind und da auch im anderen Fall die für den Transfer vom Substrat zum Probenkörper-Halter erforderliche Stabilität unter Umständen verloren gehen könnte.

Für die letzten Phasen der Laserbearbeitung zum Zwecke des Abdünnens des Zielabschnitts ZA und zum weitgehenden Freilegen des Zielvolumens wird vorzugsweise ein Ultrakurzpulslaser verwendet. Hierdurch kann eine hinreichende Schädigungsarmut der freigelegten Flanken erzielt werden, wodurch nur noch eine geringfügige und damit zeitsparende Nachbearbeitung mittels lonenstrahl erforderlich wird. Auch Kurzpulslaser können ggf. verwendet werden. Im Allgemeinen sollte die Art des Laser so gewählt werden, dass die Schädigungsdicke nicht größer als die ohnehin stabilitätsbedingt abzutragende Materialschicht ist.

Bei der beispielhaft dargestellten Geometrie des Probenkörpers und des Probenkörper-Halters aus Fig. 3 ist eine finale Nachdünnung des zwischen den Haltestegen frei liegenden Zielabschnitts im Bereich des Zielvolumens bis zur Elektronentransparenz mithilfe eines fokussierten lonenstrahls IS-F möglich, also eine FIB-Bearbeitung. Aufgrund des Umstands, dass der Zielabschnitt ZA in den vorgeschalteten Laserbearbeitungsstufen schon stark zurückgedünnt wurde, können die Vorteile dieser Technologie hinsichtlich Schädigungsarmut und Zielgenauigkeit voll genutzt werden, ohne die Nachteile einer zu langen Bearbeitungszeit in Kauf nehmen zu müssen.

Alternativ kann eine Nachdünnung auch mit einem lonenbreitstrahl erfolgen, also einem breiteren, nicht besonders fokussierten lonenstrahl, z.B. mit Argon-Ionen oder anderen Edelgas-Ionen, die wenig reaktiv sind

Alternativ zum Kleben könnte man die beiden elastisch deformierbaren metallischen Haltestege in einem Beladetool vorspannen, so dass der Probenkörper durch Aufspreizen der Haltestege zwischen diesen geklemmt werden kann. Dadurch könnte auf Kleber verzichtet werden. Auch eine kleberfreie rastende Halterung mit teilweisem Formschluss ist bei entsprechender Gestaltung möglich.

Um eine ungewollte Rücksetzung von nicht zum Abdünnen vorgesehenen Bereichen zu vermeiden, kann hier eine Abschattung vorteilhaft sein, die ähnlich der bekannten Vorgehensweise bei der Drahtabschattung dazu führen kann, dass trotz großflächiger lonenbestrahlung ein örtlich genau definiertes Zielvolumen freigelegt werden kann.

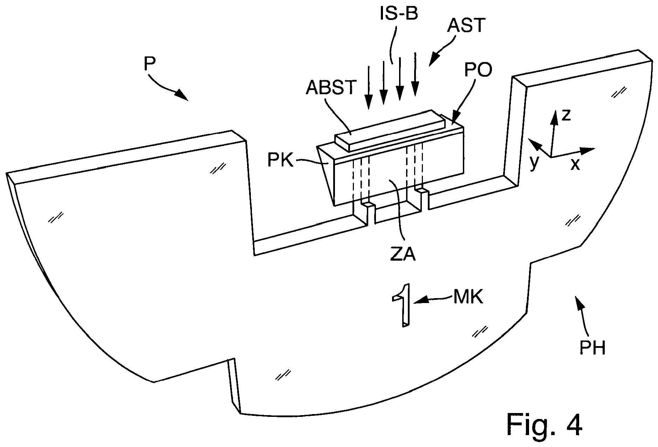

Fig. 4 zeigt ein Beispiel für einen Probenkörper-Halter PH, dessen Aufnahmestrukturen AST einen an die Probenkörper-Oberseite angepassten Abschattungssteg ABST aufweisen, der sich in x-Richtung erstreckt und beim Fixieren des Probenkörpers PK an den Haltestegen im Bereich des plattenförmigen Zielabschnitts ZA einen Teil von dessen Probenkörper-Oberseite PO abdeckt. Bei dem aus einer Titan-Folie durch Laserbearbeitung hergestellten Probenkörper-Halter ist der einstückig mit dem Rest des Probenkörper-Halters ausgebildete Abschattungssteg ebenfalls aus Titan, welches gegenüber dem Halbleiterwerkstoff des Probenkörpers PK eine wesentlich niedrigere Ätzrate unter Argon-Ionenbeschuss aufweist. Das Material des Abschattungsstegs schützt den unmittelbar darunter befindlichen Volumenbereich des Zielabschnitts so lange gegen lonenangriff, bis das Material des Abschattungsstegs weitgehend aufgebraucht ist. Die lonenstrahlbearbeitung mit einem unfokussierten Ionenbreitstrahl IS-B wird dann beendet, wenn unterhalb des weitgehend abgeätzten Abschattungsstegs ein Zielvolumen geeignet geringer Dicke (in y-Richtung) übrig bleibt und bevor auch dieses Zielvolumen durch die Ionen weggeätzt ist. Auf diese Weise kann auch bei Verwendung eines deutlich kostengünstiger zu erzeugenden lonenbreitstrahls zum Nachdünnen eine Zielpräparation von Querschnittsproben mit oberflächennahen Schichten durchgeführt werden.

Es ist möglich, den Querschnitt des Abschattungsstegs oder Abschattungsbalkens durch Lasermikrobearbeitung so abzuändern, dass eine Spitzdachstruktur entsteht, die den Prozess des lonenstrahldünnens fördert. Daran schließt sich statt einer Nachdünnung mittels fokussierten lonenstrahls nur noch eine lonenstrahlbearbeitung mit einer Breitstrahl-Ionenbearbeitungsmaschine an.

Zur weiteren Erhöhung des Durchsatzes kann ein Probenkörper-Halter auch mehr als eine Aufnahmestruktur aufweisen, beispielsweise zwei identische, nebeneinanderliegende Aufnahmestrukturen AST1, AST2, die jeweils Haltestege wie die Aufnahmestruktur aus Fig. 3 aufweisen (Fig. 5), um jeweils einen Probenkörper aufzunehmen.

Ferner können an Seitenbereichen von Probenkörper-Haltern paarweise komplementäre Passstücke PS1, PS1 ausgearbeitet werden, die es erlauben, zwei Probenkörper-Halter PH1, PH2 mit daran fixierten Probenkörpern gemeinsam als Probe P zu nutzen und in einen entsprechenden Halter einer Mikrostruktur-Untersuchungsanlage, z.B. in einen Standard-Probenhalter eines Transmissionselektronenmikroskops, einzubauen (vgl. Fig. 6). Auf diese Weise kann nicht nur die Effizienz der Präparation, sondern auch die Effizienz der nachfolgenden Analyse gesteigert werden, da unter anderem Schleusenzeiten reduziert oder vermieden werden können.

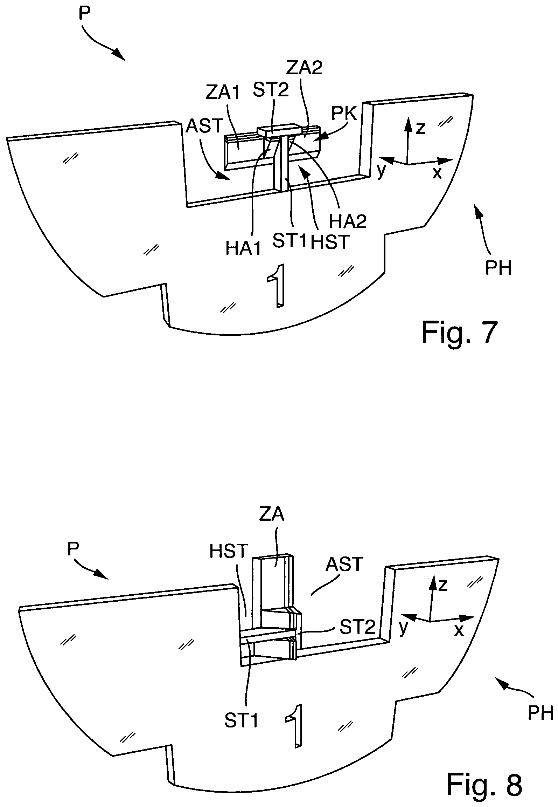

Abweichend von den bisher beschriebenen Beispielen sind zahlreiche Varianten möglich. Beispielsweise ist es nicht erforderlich, dass ein Handhabungsabschnitt oder beide Handhabungsabschnitte am Rande bzw. am Ende eines Probenkörpers angeordnet sind. Bei dem Ausführungsbeispiel in Fig. 7 weist der Probenkörper PK zwei Handhabungsabschnitte HA1, HA2 auf, die in Längsrichtung (x-Richtung) des Probenkörpers etwa in dessen Mittelbereich angeordnet sind, so dass auf einer Seite des Paars von Handhabungsabschnitten ein erster Zielabschnitt ZA1 und an der gegenüberliegenden Seite ein zweiter Zielabschnitt ZA2 vorliegt. Die dünnen, plattenförmigen Zielabschnitte liegen also an den freien Enden des Probenkörpers, während dessen Halterung im mittleren Bereich stattfindet.

Der an diese Gestalt des Probenkörpers angepasste Probenkörper-Halter PH in Fig. 7 hat Aufnahmestrukturen AST, die durch einen einzigen, T-förmigen Haltesteg HST gebildet sind. Dieser hat einen in z-Richtung verlaufenden längeren Stegabschnitt ST1, an dessen freiem Ende ein in Längsrichtung beidseits abragender kürzerer zweiter Stegabschnitt ST2 ausgebildet ist. Der in x-Richtung gemessene lichte Abstand zwischen den beiden Handhabungsabschnitten ist dabei geringfügig größer als die in dieser Richtung gemessene Breite des ersten Stegabschnitts ST1, so dass der Probenkörper weitgehend spielfrei in y-Richtung auf den ersten Stegabschnitt ST1 aufgeschoben werden kann. Zwischen den Handhabungsabschnitten befindet sich in der Flucht der Zielabschnitte ein Zwischenabschnitt, der als Anschlag in y-Richtung dient. Der quer liegende Stegabschnitt ST2 bildet einen oberen, in z-Richtung wirksamen Anschlag für den Probenkörper, an dem dieser mit seiner Probenkörper-Oberseite PO anliegt. Der Probenkörper ist wie bei den anderen Beispielen durch Kleben am Haltesteg HST befestigt.

Bei der Variante aus Fig. 8 hat der Haltesteg HST der Aufnahmestrukturen AST ebenfalls eine T-Form, jedoch ist hier der längere erste Stegabschnitt ST1 in x-Richtung (horizontal in Fig. 8) ausgerichtet, während der dazu senkrechte Querbalken bzw. zweite Stegabschnitt ST2 parallel zur z-Richtung ausgerichtet ist. Der Probenkörper PK hat zwei Handhabungsabschnitte HA1, HA2, die über ein Zwischenstück verbunden sind und zwischen denen sich ein Zwischenraum in der Breite der Dicke des ersten Stegabschnitts ST2 befindet. Das Paar von Handhabungsabschnitten befindet sich insgesamt in einem Endbereich des Probenkörpers, während der Zielabschnitt ZA sich einseitig bis zum anderen Endbereich erstreckt und im vorliegenden Fall parallel zur z-Richtung ausgerichtet ist. Ein derart "aufrecht" ausgerichteter Probenkörper kann beispielsweise für die Präparation einer Probe für die Atomsonden-Tomographie (LEAP) oder für die Röntgentomographie / Röntgenmikroskopie dienen.

Es ist ersichtlich, dass im Rahmen von Varianten der vorliegenden Erfindung ein letzter Schritt des lonenstrahlabdünnens sowohl mit jeder Art von fokussierter lonenstrahlbearbeitung (Ga-Ionen/Plasma-FIB) als auch durch Breitstrahlionenätzen erfolgen kann.

Wie z.B. in den Figuren 4 bis 8 gezeigt können Markierungen MK in Form von Ziffern oder dergleichen in den Probenkörper-Halter eingebracht werden, z.B. zwecks verbesserter Nachverfolgung. Dies ist mittels Laserstrahl einfach möglich.

Einige Aspekte der vorliegenden Erfindung wurden am Beispiel von Proben für die Transmissionselektronenmikroskopie erläutert. Der Nutzen der Erfindung ist hierauf jedoch nicht beschränkt. Proben für zahlreiche andere Mikrostrukturdiagnostikverfahren können ebenfalls nach dem beschriebenen Verfahren oder Varianten davon präpariert werden.

Beispielsweise werden Verfahren zur Abbildung mit Röntgenstrahlen eingesetzt, die außerhalb von Synchrotronstrahlungsquellen lange Zeit reine tomographische Schattenwurfverfahren waren (Röntgen-Computertomographie) und in den letzten Jahren eine Entwicklung hin zur Röntgenmikroskopie genommen haben. Bei letzterem Verfahren (X-ray microscopy, XRM) erfolgt eine zweistufige Vergrößerung. Dem Schattenwurfprinzip ist dabei eine Nachvergrößerung nachgeschaltet. Aufgrund des Durchdringungsvermögens von Röntgenstrahlung und dem Umstand geschuldet, dass für die hochaufgelöste Untersuchung der 3D-Struktur die Probe zwischen Röntgenquelle und Detektor rotiert werden muss, ist eine Anforderung an XRM-Proben, dass sie einen geringen Durchmesser (typisch: wenige bis einige 10 µm) haben. Dafür ist eine Präparation mittels Lasermikrobearbeitung ebenfalls gut geeignet.

## Patentansprüche

1. Verfahren zur Präparation einer Probe (P) für die Mikrostrukturdiagnostik, worin durch materialabtragende Laserstrahlbearbeitung aus einem Substrat ein Probenkörper (PK) mit vorgebbarer Gestalt präpariert und anschließend ein Zielabschnitt (ZA) des Probenkörpers mittels Laserstrahlbearbeitung und/oder lonenstrahlbearbeitung zur Freilegung eines für ein Mikrostrukturuntersuchung geeigneten Zielvolumens (ZV) weiterbearbeitet wird, mit folgenden Schritten:
(a) Freistellen des Probenkörpers (PK) aus dem Substrat mittels mindestens einer Laserbearbeitungsoperation durch Einstrahlen mindestens eines Laserstrahls senkrecht und/oder schräg zu einer Substratoberfläche (SO) derart, dass ein Probenkörper entsteht, welcher an einer Probenkörper-Oberseite (PO) durch einen Bereich der Substratoberfläche sowie seitlich durch schräg oder senkrecht zu der Substratoberfläche orientierte Seitenflächen (S1, S2, S3) begrenzt ist,
wobei eine Gestalt des Probenkörpers erzeugt wird, die mindestens einen massiven Handhabungsabschnitt (HA, HA1, HA2) und angrenzend an den Handhabungsabschnitt einen relativ zum Handhabungsabschnitt dünneren Zielabschnitt (ZA) aufweist, welcher an einer Schmalseite durch die Probenkörper-Oberseite (PO) und seitlich durch senkrecht oder schräg zur Probenkörper-Oberseite verlaufende Seitenflächen (S1, S3) begrenzt ist, wobei der Probenkörper (PK) derart gestaltet wird, dass zwischen dem Zielabschnitt (ZA) und einem angrenzenden Handhabungsabschnitt (HA1, HA2) ein Innenwinkel (IW) entsteht, an welchem eine Seitenfläche (S3) des Zielabschnitts und eine Seitenfläche des Handhabungsabschnitts (HA1, HA2) unter einem Winkel zusammentreffen;
(b) Herstellen eines von dem Probenkörper gesonderten Probenkörper-Halters (PH), der an die Gestalt des Probenkörpers angepasste Aufnahmestrukturen zum Aufnehmen des Probenkörpers in einer definierten Aufnahmeposition aufweist, wobei die Aufnahmestrukturen einen oder mehrere Haltestege (HST1, HST2) zum Fixieren des Probenkörpers aufweisen und an einem Haltesteg ein an den Innenwinkel (IW) angepasster Außenwinkel ausgebildet ist;
(c) Entnehmen des freigestellten Probenkörpers aus dem Substrat;
(d) Fixieren des aus dem Substrat entnommenen Probenkörpers an den Aufnahmestrukturen des Probenkörper-Halters, wobei beim Fixieren des Probenkörpers (PK) am Probenkörper-Halter (PH) ein definierter Flächenkontakt an zwei winklig zueinanderstehenden Flächen des Innenwinkels (IW) und des Außenwinkels des Haltestegs erzeugt wird, so dass die Position des Probenkörpers bezüglich des Probenkörper-Halters zumindest in zwei zueinander senkrechten Richtungen festgelegt ist;
(e) Durchführen mindestens einer weiteren materialabtragenden Bearbeitung mindestens einer Seitenfläche des Probenkörpers im Bereich des Zielabschnitts mittels Laserstrahlbearbeitung und/oder lonenstrahlbearbeitung zur Freilegung des Zielvolumens.

2. Verfahren nach Anspruch 1, **dadurch gekennzeichnet, dass** der Probenköper (PK) an den Aufnahmestrukturen (AST) durch Kleben oder Klemmen befestigt wird.

3. Verfahren nach Anspruch 1 oder 2, **dadurch gekennzeichnet, dass** ein erster Handhabungsabschnitt (HA1) und ein zweiter Handhabungsabschnitt (HA2) erzeugt wird, wobei zwischen dem ersten Handhabungsabschnitt und dem zweiten Handhabungsabschnitt ein dünnerer Zwischenabschnitt liegt, wobei vorzugsweise der Zwischenabschnitt als Zielabschnitt (ZA) ausgelegt ist.

4. Verfahren nach einem der vorhergehenden Ansprüche, **dadurch gekennzeichnet, dass** beim Schritt (a) des Freistellens an mindestens einer Stelle einer Seitenfläche des Handhabungsabschnitts eine Haltestruktur (HS) aus Substratmaterial verbleibt, welche den ansonsten freigestellten Probenkörper im Bereich des Handhabungsabschnitts (HA) mit einem angrenzenden Abschnitt des Substrats (SUB) verbindet, so dass der Probenkörper (PK) nur über die Haltestruktur mit den Rest des Substrats verbunden ist, wobei vorzugsweise im Schritt (c) das Entnehmen des Probenkörpers eine Trennung der Verbindung zwischen dem Probenkörper und dem Substrat im Bereich der Haltestruktur bewirkt.

5. Verfahren nach einem der vorhergehenden Ansprüche, **dadurch gekennzeichnet, dass** beim Schritt (a) des Freistellens angrenzend an mindestens eine der Seitenflächen bei der Laserstrahlbearbeitung ein Volumenbereich (VOL) aus Substratmaterial beseitigt wird, welcher senkrecht zu der Seitenfläche eine Breite (B) aufweist, die ein Vielfaches der Breite einer Laserstrahl-Schnittbahn aufweist, wobei vorzugsweise die Breite (B) des Volumenbereichs bei 200 µm oder mehr, insbesondere im Bereich von 300 µm bis 400 µm, liegt.

6. Verfahren nach Anspruch 5, **dadurch gekennzeichnet, dass** der Volumenbereich (VOL) sukzessive durch scannende Führung eines fokussierten Laserstrahls beseitigt wird.

7. Verfahren nach einem der vorhergehenden Ansprüche, **dadurch gekennzeichnet, dass** beim Schritt (a) des Freilegens der Probenkörper derart erzeugt wird, dass eine senkrecht zur Substratoberfläche gemessene Ausdehnung des Probenkörpers (PK) geringer ist als eine senkrecht zur Substratoberfläche gemessene Dicke des Substrats (SUB), wobei vorzugsweise beim Schritt (a) des Freilegens in einem Zwischenschritt mittels Laserstrahlbearbeitung zwei in einem Winkel zueinander stehende, gegenüber liegende Seitenflächen (S1, S3) erzeugt werden, welche sich in einer im Inneren des Substrats liegenden Schnittlinie schneiden.

8. Verfahren nach einem der vorhergehenden Ansprüche, **dadurch gekennzeichnet, dass** das Substrat im Bereich der Substratoberfläche eine oder mehrere durch Grenzflächen (G1) getrennte Schichten (L1, L2) oder Schichtsegmente aufweist, wobei der Probenkörper derart erzeugt wird, dass eine oder mehrere Grenzflächen im Wesentlichen senkrecht zu mindestens einer Seitenfläche (S3) des Zielabschnitts (ZA) orientiert ist.

9. Verfahren nach einem der vorhergehenden Ansprüche, **dadurch gekennzeichnet, dass** die Seitenfläche (S3) des Zielabschnitts und die Seitenfläche des Handhabungsabschnitts (HA1, HA2) am Innenwinkel (IW) unter einem rechten Winkel zusammentreffen.

10. Verfahren nach einem der vorhergehenden Ansprüche, **dadurch gekennzeichnet, dass** der Probenkörper-Halter (PH) aus einem Halter-Material gefertigt wird, welches sich vom Substratmaterial unterscheidet, wobei vorzugsweise das Halter-Material ein Metall aufweist oder ein Metall ist, insbesondere Titan.

11. Verfahren nach einem der vorhergehenden Ansprüche, **dadurch gekennzeichnet, dass** der Probenkörper-Halter mittels Laserbearbeitung aus einer Platte oder einer Folie des Halter-Materials hergestellt wird.

12. Verfahren nach einem der vorhergehenden Ansprüche, **dadurch gekennzeichnet, dass** ein Haltesteg einen ersten Stegabschnitt (ST1) und einen in einem Winkel zum ersten Stegabschnitt ausgerichteten zweiten Stegabschnitt (ST2) aufweist, wobei der Winkel vorzugsweise ein rechter Winkel ist und/oder wobei ein Haltesteg eine T-Form oder eine L-Form aufweist.

13. Verfahren nach einem der vorhergehenden Ansprüche, **dadurch gekennzeichnet, dass** die Aufnahmestrukturen (AST) einen an die Probenkörper-Oberseite angepassten Abschattungssteg (ABST) aufweisen, der aus einem Material besteht, welches bei lonenbestrahlung und/oder Laserbestrahlung eine niedrigere Abtragsrate aufweist als das Substratmaterial.

14. Verfahren nach einem der vorhergehenden Ansprüche, **dadurch gekennzeichnet, dass** vor dem Fixieren des Probenkörpers an den Aufnahmestrukturen auf die Probenkörper-Oberseite mindestens im Bereich der Schmalseite des Zielabschnitts eine Opferschicht aufgebracht wird, die aus einem Material besteht, welches bei lonenbestrahlung und/oder Laserbestrahlung eine niedrigere Abtragsrate aufweist als das Substratmaterial.

15. Probe für die Mikrostrukturdiagnostik mit:
einem Probenkörper-Halter (PH) mit an die Gestalt eines Probenkörpers angepassten Aufnahmestrukturen zum Aufnehmen eines Probenkörpers in einer definierten Aufnahmeposition, wobei die Aufnahmestrukturen einen oder mehrere Haltestege (HST1, HST2) zum Fixieren des Probenkörpers aufweisen und an einem Haltesteg ein an den Innenwinkel (IW) angepasster Außenwinkel ausgebildet ist; und
mindestens einem gesondert von dem Probenkörper-Halter hergestellten Probenkörper (PK), welcher mindestens einen massiven Handhabungsabschnitt (HA, HA1, HA2) und angrenzend an den Handhabungsabschnitt einen relativ zum Handhabungsabschnitt dünneren Zielabschnitt (ZA) aufweist, der an einer Schmalseite durch eine Probenkörper-Oberseite (PO) und seitlich durch senkrecht oder schräg zur Probenkörper-Oberseite verlaufende Seitenflächen (S1, S3) begrenzt ist, wobei der Probenkörper (PK) zwischen dem Zielabschnitt (ZA) und einem angrenzenden Handhabungsabschnitt (HA1, HA2) ein Innenwinkel (IW) aufweist, an welchem eine Seitenfläche (S3) des Zielabschnitts und eine Seitenfläche des Handhabungsabschnitts (HA1, HA2) unter einem Winkel zusammentreffen;
wobei der Probenkörper an den Aufnahmestrukturen in der Aufnahmeposition derart fixiert ist, dass ein definierter Flächenkontakt an zwei winklig zueinander stehenden Flächen des Innenwinkels (IW) und des Außenwinkels des Haltestegs besteht, so dass die Position des Probenkörpers (PK) bezüglich des Probenkörper-Halters (PKH) zumindest in zwei zueinander senkrechten Richtungen festgelegt ist;

## Claims

1. Method for preparing a sample (P) for microstructure diagnostics, wherein a sample body (PK) with a predeterminable form is prepared from a substrate by way of material-ablating laser beam processing and subsequently a target portion (ZA) of the sample body is processed further by way of laser beam processing and/or ion beam processing in order to expose a target volume (ZV) that is suitable for a microstructure examination, comprising the following steps:
(a) releasing the sample body (PK) from the substrate by means of at least one laser processing operation by radiating-in at least one laser beam in a manner perpendicular and/or oblique to a substrate surface (SO) in such a way that a sample body arises, said sample body being delimited at a sample body top side (PO) by a region of the substrate surface and, laterally, by side faces (S1, S2, S3) oriented in an oblique or perpendicular manner in relation to the substrate surface,
wherein a form of the sample body is generated, which form has at least one solid handling portion (HA, HA1, HA2) and, adjoining the handling portion, a target portion (ZA) which is thinner relative to the handling portion, said target portion being delimited at a narrow side by the sample body top side (PO) and, laterally, by side faces (S1, S3) extending in a perpendicular or oblique manner in relation to the sample body top side, wherein the sample body (PK) is designed in such a way that an interior angle (IW) arises between the target portion (ZA) and an adjoining handling portion (HA1, HA2), with a side face (S3) of the target portion and a side face of the handling portion (HA1, HA2) intersecting at an angle at said interior angle;
(b) producing a sample body holder (PH) which is separate from the sample body and which has accommodation structures adapted to the form of the sample body for the purposes of accommodating the sample body in a defined accommodation position, wherein the accommodation structures have one or more holding webs (HST1, HST2) for affixing the sample body and an exterior angle adapted to the interior angle (IW) is formed on a holding web;
(c) removing the sample body that was released from the substrate;
(d) affixing the sample body removed from the substrate to the accommodation structures of the sample body holder, wherein a defined area contact is generated at two faces at an angle to one another of the interior angle (IW) and of the exterior angle of the holding web when affixing the sample body (PK) to the sample body holder (PH), and so the position of the sample body in respect of the sample body holder is set in at least two mutually perpendicular directions;
(e) carrying out at least one further material-ablating processing step of at least one side face of the sample body in the region of the target portion by means of laser beam processing and/or ion beam processing for the purposes of exposing the target volume.

2. Method according to Claim 1, **characterized in that** the sample body (PK) is fastened to the accommodation structures (AST) by adhesive bonding or clamping.

3. Method according to Claim 1 or 2, **characterized in that** a first handling portion (HA1) and a second handling portion (HA2) are generated, wherein a thin intermediate portion lies between the first handling portion and the second handling portion, the intermediate portion preferably being configured as target portion (ZA).

4. Method according to one of the preceding claims, **characterized in that** a holding structure (HS) made of substrate material remains at at least one point of a side face of the handling portion during release step (a), said holding structure connecting the otherwise released sample body in the region of the handling portion (HA) with an adjoining portion of the substrate (SUB) such that the sample body (PK) is only connected to the remainder of the substrate by way of the holding structure, with the removal of the sample body in step (c) preferably causing a separation of the connection between the sample body and the substrate in the region of the holding structure.

5. Method according to one of the preceding claims, **characterized in that** a volume region (VOL) made of substrate material is disposed of adjacent to at least one of the side faces during the laser beam processing within the scope of release step (a), said volume region having a width (B) perpendicular to the side face which is a multiple of the width of a laser beam cutting path, the width (B) of the volume region preferably being 200 µm or more, in particular in the range between 300 µm and 400 µm.

6. Method according to Claim 5, **characterized in that** the volume region (VOL) is disposed of successively by the scanning guidance of a focused laser beam.

7. Method according to one of the preceding claims, **characterized in that** the sample body is generated in such a way during the release step (a) that an extent of the sample body (PK) measured perpendicular to the substrate surface is less than a thickness of the substrate (SUB) measured perpendicular to the substrate surface, wherein preferably, within the scope of release step (a), two side faces (S1, S3) which are angled in relation to one another and lying opposite one another are generated in an intermediate step by means of laser beam processing, which side faces intersect at a line of intersection lying in the interior of the substrate.

8. Method according to one of the preceding claims, **characterized in that**, in the region of the substrate surface, the substrate has one or more layers (L1, L2) or layer segments separated by interfaces (G1), the sample body being generated in such a way that one or more interfaces are oriented substantially perpendicular to at least one side face (S3) of the target portion (ZA).

9. Method according to one of the preceding claims, **characterized in that** the side face (S3) of the target portion and the side face of the handling portion (HA1, HA2) intersect at a right angle at the interior angle (IW).

10. Method according to one of the preceding claims, **characterized in that** the sample body holder (PH) is manufactured from a holder material which differs from the substrate material, with the holder material preferably comprising a metal or being a metal, in particular titanium.

11. Method according to one of the preceding claims, **characterized in that** the sample body holder is produced by means of laser processing from a plate or a film of the holder material.

12. Method according to one of the preceding claims, **characterized in that** a holding web has a first web portion (ST1) and a second web portion (ST2) oriented at an angle to the first web portion, with the angle preferably being a right angle and/or a holding web having a T-shape or an L-shape.

13. Method according to one of the preceding claims, **characterized in that** the accommodation structures (AST) have a shadowing web (ABST) adapted to the sample body top side, said shadowing web consisting of a material which has a lower ablation rate than the substrate material in the case of ion irradiation and/or laser irradiation.

14. Method according to one of the preceding claims, **characterized in that**, prior to affixing the sample body to the accommodation structures, a sacrificial layer is applied onto the sample body top side, at least in the region of the narrow side of the target portion, said sacrificial layer consisting of a material which has a lower ablation rate than the substrate material in the case of ion irradiation and/or laser irradiation.

15. Sample for microstructure diagnostics comprising:
a sample body holder (PH) with accommodation structures, adapted to the form of a sample body, for accommodating a sample body in a defined accommodation position, wherein the accommodation structures have one or more holding webs (HST1, HST2) for affixing the sample body and an exterior angle adapted to the interior angle (IW) is formed on a holding web; and
at least one sample body (PK) produced separately from the sample body holder, said sample body having at least one solid handling portion (HA, HA1, HA2) and, adjoining the handling portion, a target portion (ZA) which is thinner relative to the handling portion, said target portion being delimited at a narrow side by a sample body top side (PO) and, laterally, by side faces (S1, S3) extending in a perpendicular or oblique manner in relation to the sample body top side, wherein the sample body (PK) has an interior angle (IW) between the target portion (ZA) and an adjoining handling portion (HA1, HA2), with a side face (S3) of the target portion and a side face of the handling portion (HA1, HA2) intersecting at an angle at said interior angle;
wherein the sample body is affixed to the accommodation structures in the accommodation position in such a way that a defined area contact exists at two faces at an angle to one another of the interior angle (IW) and of the exterior angle of the holding web, and so the position of the sample body (PK) in respect of the sample body holder (PKH) is set in at least two mutually perpendicular directions;

## Revendications

1. Procédé de préparation d'un échantillon (P) pour le diagnostic de microstructure, dans lequel, par un usinage par faisceau laser et enlèvement de matière, une éprouvette (PK) de forme prédéfinissable est préparée à partir d'un substrat, et ensuite une partie cible (ZA) de l'éprouvette est transformée au moyen d'un usinage par faisceau laser et/ou d'un usinage par faisceau ionique pour exposer un volume cible (ZV) approprié pour un examen de microstructure, comprenant les étapes suivantes consistant à :
(a) dégager l'éprouvette (PK) du substrat au moyen d'au moins une opération d'usinage au laser par irradiation d'au moins un faisceau laser perpendiculairement et/ou en biais par rapport à une surface de substrat (SO) de façon à créer une éprouvette qui est délimitée sur une face supérieure d'éprouvette (PO) par une zone de la surface de substrat ainsi que latéralement par des surfaces latérales (S1, S2, S3) orientées en biais ou perpendiculairement à la surface de substrat,
dans lequel une forme de l'éprouvette est générée qui présente au moins une partie de manipulation pleine (HA, HA1, HA2), et de manière adjacente à la partie de manipulation, une partie cible (ZA) plus fine par rapport à la partie de manipulation et qui est délimitée sur un petit côté par la face supérieure d'éprouvette (PO) et latéralement par des surfaces latérales (S1, S3) s'étendant perpendiculairement ou en biais par rapport à la face supérieure d'éprouvette, l'éprouvette (PK) étant configurée de telle sorte qu'entre la partie cible (ZA) et une partie de manipulation adjacente (HA1, HA2) se forme un angle intérieur (IW) au niveau duquel une surface latérale (S3) de la partie cible et une surface latérale de la partie de manipulation (HA1, HA2) se rencontrent selon un angle ;
(b) fabriquer un support d'éprouvette (PH) séparé de l'éprouvette et qui présente des structures de réception adaptées à la forme de l'éprouvette pour recevoir l'éprouvette dans une position de réception définie, dans lequel les structures de réception présentent une ou plusieurs pattes de retenue (HST1, HST2) pour fixer l'éprouvette, et un angle extérieur adapté à l'angle intérieur (IW) est réalisé sur une patte de retenue ;
(c) retirer l'éprouvette dégagée du substrat ;
(d) fixer l'éprouvette retirée du substrat aux structures de réception du support d'éprouvette, dans lequel, lors de la fixation de l'éprouvette (PK) au support d'éprouvette (PH), un contact de surface défini est généré au niveau de deux surfaces, placées en formant un angle l'une par rapport à l'autre, de l'angle intérieur (IW) et de l'angle extérieur de la patte de retenue de sorte que la position de l'éprouvette par rapport au support d'éprouvette est définie au moins dans deux directions perpendiculaires l'une à l'autre ;
(e) effectuer au moins un autre usinage à enlèvement de matière d'au moins une surface latérale de l'éprouvette au niveau de la partie cible au moyen d'un usinage par faisceau laser et/ou d'un usinage par faisceau ionique pour exposer le volume cible.

2. Procédé selon la revendication 1, **caractérisé en ce que** l'éprouvette (PK) est fixée aux structures de réception (AST) par collage ou par serrage.

3. Procédé selon la revendication 1 ou 2, **caractérisé en ce qu'**une première partie de manipulation (HA1) et une deuxième partie de manipulation (HA2) sont générées, dans lequel, entre la première partie de manipulation et la deuxième partie de manipulation se trouve une partie intermédiaire plus fine, la partie intermédiaire étant de préférence conçue comme une partie cible (ZA).

4. Procédé selon l'une quelconque des revendications précédentes, **caractérisé en ce qu'**à l'étape (a) du dégagement, à au moins un endroit d'une surface latérale de la partie de manipulation, il reste une structure de retenue (HS) en matériau de substrat qui relie l'éprouvette par ailleurs dégagée au niveau de la partie de manipulation (HA) à une partie adjacente du substrat (SUB) de sorte que l'éprouvette (PK) n'est reliée que par la structure de retenue au reste du substrat, dans lequel de préférence à l'étape (c), le retrait de l'éprouvette provoque une séparation de la liaison entre l'éprouvette et le substrat au niveau de la structure de retenue.

5. Procédé selon l'une quelconque des revendications précédentes, **caractérisé en ce qu'**à l'étape (a) du dégagement, de manière adjacente à au moins l'une des surfaces latérales, lors de l'usinage par faisceau laser, une zone de volume (VOL) en matériau de substrat est éliminée qui présente perpendiculairement à la surface latérale une largeur (B) qui présente un multiple de la largeur d'une trajectoire de coupe de faisceau laser, dans lequel de préférence la largeur (B) de la zone de volume se situe à 200 µm ou plus, en particulier dans la plage de 300 µm à 400 µm.

6. Procédé selon la revendication 5, **caractérisé en ce que** la zone de volume (VOL) est éliminée successivement par un guidage de balayage d'un faisceau laser focalisé.

7. Procédé selon l'une quelconque des revendications précédentes, **caractérisé en ce qu'**à l'étape (a) du dégagement, l'éprouvette est générée de telle sorte qu'une extension mesurée perpendiculairement à la surface de substrat de l'éprouvette (PK) est inférieure à une épaisseur du substrat (SUB) mesurée perpendiculairement à la surface de substrat, dans lequel de préférence à l'étape (a) du dégagement, dans une étape intermédiaire, au moyen d'un usinage par faisceau laser, deux surfaces latérales (S1, S3) opposées, se trouvant à un angle l'une par rapport à l'autre, sont générées qui se coupent sur une ligne d'intersection située à l'intérieur du substrat.

8. Procédé selon l'une quelconque des revendications précédentes, **caractérisé en ce que** le substrat présente au niveau de la surface de substrat une ou plusieurs couches (L1, L2) ou segments de couche, séparés par des couches de séparation (G1), dans lequel l'éprouvette est générée de telle sorte qu'une ou plusieurs couches de séparation sont orientées de manière substantiellement perpendiculaire à au moins une surface latérale (S3) de la partie cible (ZA).

9. Procédé selon l'une quelconque des revendications précédentes, **caractérisé en ce que** la surface latérale (S3) de la partie cible et la surface latérale de la partie de manipulation (HA1, HA2) se rencontrent au niveau de l'angle intérieur (IW) selon un angle droit.

10. Procédé selon l'une quelconque des revendications précédentes, **caractérisé en ce que** le support d'éprouvette (PH) est fabriqué à partir d'un matériau de support qui est différent du matériau de substrat, le matériau de support présentant de préférence un métal ou étant un métal, en particulier du titane.

11. Procédé selon l'une quelconque des revendications précédentes, **caractérisé en ce que** le support d'éprouvette est fabriqué au moyen d'un usinage au laser à partir d'une plaque ou d'un film du matériau de support.

12. Procédé selon l'une quelconque des revendications précédentes, **caractérisé en ce qu'**une patte de retenue présente une première partie de patte (ST1) et une deuxième partie de patte (ST2), orientée selon un angle par rapport à la première partie de patte, l'angle étant de préférence un angle droit, et/ou une patte de retenue présentant une forme de T ou une forme de L.

13. Procédé selon l'une quelconque des revendications précédentes, **caractérisé en ce que** les structures de réception (AST) présentent une patte de recouvrement (ABST) adaptée à la face supérieure d'éprouvette et qui est composée d'un matériau qui présente un taux d'enlèvement inférieur à celui du matériau de substrat en cas d'irradiation ionique et/ou d'irradiation laser.

14. Procédé selon l'une quelconque des revendications précédentes, **caractérisé en ce qu'**avant la fixation de l'éprouvette aux structures de réception sur la face supérieure de l'éprouvette, au moins au niveau du petit côté de la zone cible, une couche sacrificielle est appliquée qui se compose d'un matériau qui présente un taux d'enlèvement inférieur à celui du matériau de substrat en cas d'irradiation ionique et/ou d'irradiation laser.

15. Echantillon pour le diagnostic de microstructure, comprenant :
un support d'éprouvette (PH) pourvu de structures de réception adaptées à la forme d'une éprouvette pour recevoir une éprouvette dans une position de réception définie, dans lequel les structures de réception présentent une ou plusieurs pattes de retenue (HST1, HST2) pour fixer l'éprouvette, et un angle extérieur adapté à l'angle intérieur (IW) est réalisé au niveau d'une patte de retenue ; et
au moins une éprouvette (PK) fabriquée séparément du support d'éprouvette et qui présente au moins une partie de manipulation pleine (HA, HA1, HA2), et de manière adjacente à la partie de manipulation, une partie cible (ZA) plus fine par rapport à la partie de manipulation et qui est délimitée sur un petit côté par une face supérieure d'éprouvette (PO) et latéralement par des surfaces latérales (S1, S3) s'étendant perpendiculairement ou en biais par rapport à la face supérieure d'éprouvette, l'éprouvette (PK) présentant entre la partie cible (ZA) et une partie de manipulation (HA1, HA2) adjacente un angle intérieur (IW) au niveau duquel une surface latérale (S3) de la partie cible et une surface latérale de la partie de manipulation (HA1, HA2) se rencontrent selon un angle ;
dans lequel l'éprouvette est fixée aux structures de réception dans la position de réception de telle sorte qu'un contact de surface définie existe au niveau de deux surfaces, disposées selon un angle l'une par rapport à l'autre, de l'angle intérieur (IW) et de l'angle extérieur de la patte de retenue de sorte que la position de l'éprouvette (PK) est définie par rapport au support d'éprouvette (PKH) au moins dans deux directions perpendiculaires l'une par rapport à l'autre.
